# EUROPEAN PATENT APPLICATION

(11) **EP 2 120 097 A1**
(43) Date of publication of application: **18.11.2009**
(21) Application number: 08721441.7
(22) Date of filing: 06.03.2008
(51) Int. Cl.: G03F 7/20, G01B 9/02, G01B 11/00, H01L 21/027

(54) **POSITION MEASURING MODULE, POSITION MEASURING APPARATUS, STAGE APPARATUS, EXPOSURE APPARATUS AND DEVICE MANUFACTURING METHOD**

(30) Priority: 08.03.2007 JP 2007057939
(71) Applicant: Nikon Corporation, Chiyoda-ku Tokyo 100-8331 (JP)
(72) Inventor: MOROE, Junichi, Tokyo 100-8331 (JP)
(74) Representative: Hooiveld, Arjen Jan Winfried
(86) International application number: PCT/JP2008/054021
(87) International publication number: WO 2008/108423

(57) **Abstract**

A position measuring module includes a movement mirror provided on a movable member and having a reflecting surface along a first axis direction; detection-light units which are arranged for a plurality of measuring axes disposed in the first axis direction respectively and which irradiate, onto the movement mirror, detection lights in a second axis direction intersecting the first axis direction; a reference-light unit which includes a fixed mirror fixed to a member different from the movable member and which irradiates a reference light onto the fixed mirror; a plurality of optical path combining elements which combines detection optical paths for the detection lights reflected by the movement mirror in relation to the measuring axes respectively or combines the detection optical paths for the detection lights and a reference optical path for the reference light via the reference-light unit; and a detecting section which detects an interference fringe brought about by interference between the detection light and the reference light coming into the detecting section via the optical path combining elements and which measures a position of the movable member in the second axis direction based on a detection result of the interference fringe.

## Description

### TECHNICAL FIELD

The present invention relates to a position measuring module for measuring a position of a movable member preferably usable for an apparatus provided with the movable member, a position measuring apparatus provided with the position measuring module, an exposure apparatus provided with the position measuring apparatus, and a device production method using the exposure apparatus.

### BACKGROUND ART

In a case that a display element device (FPD) such as a liquid crystal display element or the like is produced, a projection exposure apparatus is used, in which a pattern of a mask (for example, a reticle, a photomask, etc.) is projected onto a plate (for example, a glass plate, a semiconductor wafer, etc.) coated with, for example, a photoresist via a projection optical system to perform the exposure.

The plate is progressively large-sized as the liquid crystal display element is progressively large-sized. At present, a plate (glass substrate), which is not less than 1 m square, is also used. In accordance with this, a stage, which is movable while placing the plate thereon, is also increased in size. The position of the stage is generally measured by using a laser interferometer wherein a detection light (detection light beam) is irradiated (radiated) onto a movement mirror (lengthy mirror) provided on the stage, and a reflected light (reflected light beam) thereof and a predetermined reference light (reference light beam) are allowed to interfere so that the change of the position is measured. However, the advance of the lengthy size of the movement mirror, which is accompanied by the increase in the size of the stage, has a certain limit in view of the accuracy and the cost; and the reconsideration of the interferometer system has been investigated.

A technique is known to measure the position of the stage having a stroke longer than the size or dimension of the movement mirror in the longitudinal direction without advancing any lengthy size of the movement mirror, wherein a plurality of interferometers (detectors) are arranged while being separated from each other in the direction of movement of the stage (see, for example, Japanese Patent Application Laid-open No. H07-253304). According to this technique, the movement mirror exists on the position measuring axis of at least one interferometer irrelevant to the position of the stage. Therefore, it is possible to measure the position in the measuring direction, which is perpendicular to the direction of movement, over a stroke longer than the size or dimension of the movement mirror in the longitudinal direction.

However, in the case of the conventional technique described above, the interferometers are provided corresponding to a plurality of position measuring axes respectively. Therefore, a problem arises such that the construction is complicated and the cost is expensive. In particular, when the stroke of the stage is enlarged or becomes greater, it is necessary that a large number of position measuring axes, i.e., a large number of interferometers need to be provided; and it is difficult to easily respond to any further increase in size.

The present invention has been made taking the foregoing viewpoints into consideration, an object of which is to successfully respond to the demand for the enlargement of the movement stroke of a movable member easily at the low cost.

### DISCLOSURE OF THE INVENTION

According to the present invention, there is provided a position measuring module comprising: a movement mirror which is provided on a movable member and which has a reflecting surface along a first axis direction; detection-light units which are arranged for a plurality of measuring axes disposed in the first axis direction respectively and which irradiate, onto the movement mirror, detection lights in a second axis direction intersecting the first axis direction; a reference light-unit which includes a fixed mirror fixed to a member different from the movable member and which irradiates a reference light onto the fixed mirror; a plurality of optical path combining elements which perform optical path combination of detection optical paths for the detection lights reflected by the movement mirror in relation to the measuring axes respectively or which perform optical path combination of the detection optical paths and a reference optical path for the reference light via the reference-light unit; and a detecting section which detects an interference fringe which is brought about by interference between the detection light and the reference light coming into the detection section via the optical path combining element and which measures a position of the movable member in the second axis direction based on a detection result of the interference fringe.

The position measuring module according to the present invention is provided with the plurality of optical path combining elements which perform the optical path combination of the respective detection optical paths for the detection lights reflected by the movement mirror in relation to the measuring axes respectively or which perform the optical path combination of the detection optical paths and the reference optical path for the reference light via the reference-light unit. Therefore, the number of the detecting sections can be made smaller than the number of the measuring axes. Therefore, it is possible to simplify the construction and it is possible to realize the low cost as compared with the conventional technique in which the detecting section is provided for each of the measuring axes. In particular, in a case that the stroke of the movable member is enlarged, it is possible to respond to the enlarged stroke by increasing the number of the measuring axes (detection-light units) without increasing the number of the detecting sections; and thus it is possible to respond to the demand for the enlargement of the movement stroke of the movable member easily at the low cost.

In another aspect, according to the present invention, there is provided a position measuring apparatus which measures a position of a movable member movable in two-dimensional directions of a first axis direction and a second axis direction perpendicular to the first axis direction, the position measuring apparatus comprising: a plurality of measuring axes each of which measures a position of the movable member in the second axis direction, which are arranged separately in the first axis direction, and each of which measures the position of the movable member when the movable member is moved in the first axis direction; and a plurality of detecting sections which are provided to be opposite to the measuring axes respectively and each of which detects the position of the movable member; wherein a number of the detecting sections is smaller than a number of the measuring axes.

In the position measuring apparatus according to the present invention, the number of the detecting sections is smaller than the number of the measuring axes. Therefore, the construction is simple, and it is possible to realize the low cost of the position measuring apparatus. In particular, in a case that the stroke of the movable member such as a stage or the like is enlarged, it is necessary to provide a large number of the measuring axes. However, the number of the detecting sections is small. Therefore, it is possible to respond to the demand for the enlargement of the movement stroke of the movable member easily at the low cost.

### BRIEF DESCRIPTION OF THE DRAWINGS

Fig. 1 shows a schematic construction of an exposure apparatus of a first embodiment of the present invention.
Fig. 2 shows a schematic construction of an illumination optical system provided for the exposure apparatus of the first embodiment of the present invention.
Fig. 3 shows a planar positional relationship between a mask and field areas brought about by partial projection optical systems of the first embodiment of the present invention.
Fig. 4 shows a plan view illustrating a schematic construction of a plate stage and a stage position measuring device of the first embodiment of the present invention.
Fig. 5 shows a plan view illustrating a detailed construction of an interferometer unit of the first embodiment of the present invention.
Fig. 6 shows a plan view illustrating a detailed construction of an interferometer unit of a second embodiment of the present invention.
Fig. 7 shows a plan view illustrating a schematic construction of a plate stage and a stage position measuring device of a third embodiment of the present invention.
Fig. 8 shows a plan view illustrating a detailed construction of an interferometer unit of the third embodiment of the present invention.
Fig. 9 shows a modificaiton of the third embodiment of the present invention.
Fig. 10 shows a plan view illustrating a detailed construction of an interferometer unit of a fourth embodiment of the present invention.
Fig. 11 shows a flow chart illustrating a production method for producing a semiconductor device of an embodiment of the present invention.
Fig. 12 shows a flow chart illustrating a production method for producing a liquid crystal display element of an embodiment of the present invention.

### BEST MODE FOR CARRYING OUT THE INVENTION

Embodiments of the present invention will be described in detail below with reference to the drawings.

### First Embodiment

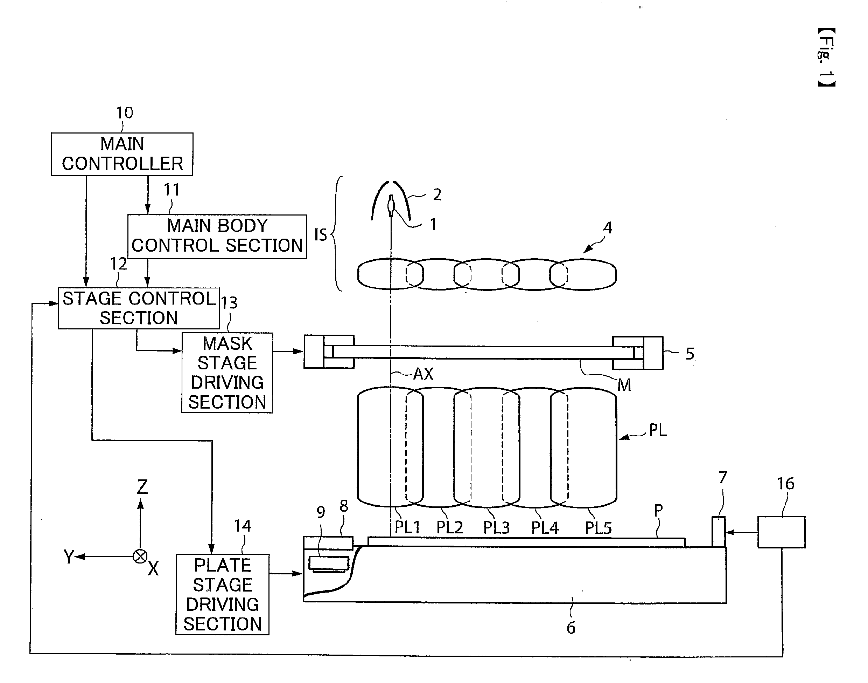

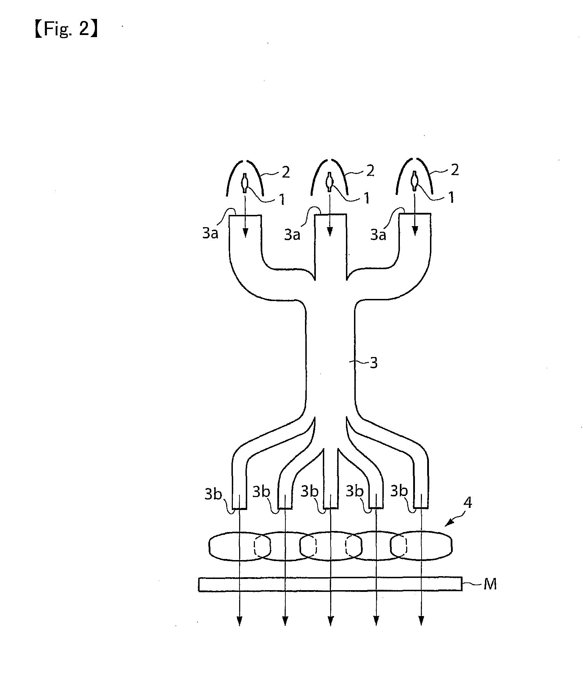

Fig. 1 shows a schematic construction of an exposure apparatus according to a first embodiment of the present invention. Fig. 2 shows a schematic construction of an illumination optical system provided for the exposure apparatus shown in Fig. 1. The exposure apparatus is a scanning type exposure apparatus in which an image of a pattern formed on a mask M is successively transferred onto a plate P (photosensitive substrate P) having a surface coated with a photosensitive agent while synchronously moving the mask M and the plate P with respect to a projection optical system PL in order to produce a liquid crystal display element.

In the following description, an XYZ rectangular coordinate system is defined. Positional relationships among respective members will be explained with reference to the XYZ rectangular coordinate system. In the XYZ rectangular coordinate system shown in Fig. 1, the Y axis and the Z axis are defined to be parallel to the sheet surface of the drawing, and the X axis is defined in a direction perpendicular to the sheet surface. Actually, in the XYZ rectangular coordinate system, the XY plane is defined in a plane parallel to a horizontal plane, and the Z axis is defined in the vertically upward direction. In this embodiment, the scanning direction (scan direction) is defined in the X direction.

With reference to Figs. 1 and 2, reference numeral 1 indicates an ultra-high voltage mercury lamp which serves as a light source and which emits light (light beam) by receiving the electric power supplied from an unillustrated power source. The lights (light beams) radiated from the ultra-high voltage mercury lamp 1 are converged by elliptic mirrors 2 respectively; and each of the lights comes into a light guide 3 from a light-incident portion 3a arranged in the vicinity of the position of the second focal point of one of the elliptic mirrors 2. The light guide 3 has such a function that the lights coming from the plurality of light-incident portions 3a are once collected and then are uniformly distributed to exit from a plurality of light-exit portions 3b. The light guide 3 is constructed, for example, by bundling a plurality of optical fibers.

The lights exiting from the light-exit portions 3b respectively of the light guide 3 pass through condenser lenses 4 to illuminate the mask M with rectangular illumination areas in which the longitudinal direction is defined to be the Y direction.

The mask M is held on a mask stage 5 which is finely movable, by an unillustrated motor, in the direction of an optical axis AX of the projection optical system PL and which is finely rotatable and two-dimensionally movable in a plane perpendicular to the optical axis AX. The mask stage 5 is constructed to be movable at a constant velocity in the X direction during the exposure. A movement mirror (not shown), which reflects a laser beam (laser light beam, laser light) from an unillustrated laser interferometer, is fixed to an end portion of the mask stage 5. The two-dimensional position and the angle of rotation of the mask stage 5 are always detected at a predetermined resolution by the laser interferometer. Detection results obtained by the laser interferometer are outputted to a stage control section 12. The stage control section 12 drives a mask stage driving section 13 to control the operation of the mask stage 5 in accordance with a control signal from a main controller 10 while making reference to the detection results of the laser interferometer.

The pattern image of the mask M is projected onto the plate P via the projection optical system PL constructed of partial projection optical systems PL1 to PL5 provided in an arranged manner in the Y direction. In this embodiment, optical systems of the erecting non-reverse image type are used as the partial projection optical systems PL1 to PL5. Exposure light (exposure beam), which is irradiated (radiated) onto the plate P, is shaped by an aperture of a field diaphragm arranged in each of the partial projection optical systems PL1 to PL5, and the exposure light is allowed to have a substantially trapezoidal external shape.

First exposure areas, which are arranged in the Y direction, are formed on the plate P by the partial projection optical systems PL1, PL3, PL5; and second exposure areas, which are arranged in the Y direction at positions different from those of the first exposure areas, are formed on the plate P by the partial projection optical systems PL2, PL4. The first and second exposure areas are erecting 1X magnification images of field areas EA1 to EA5.

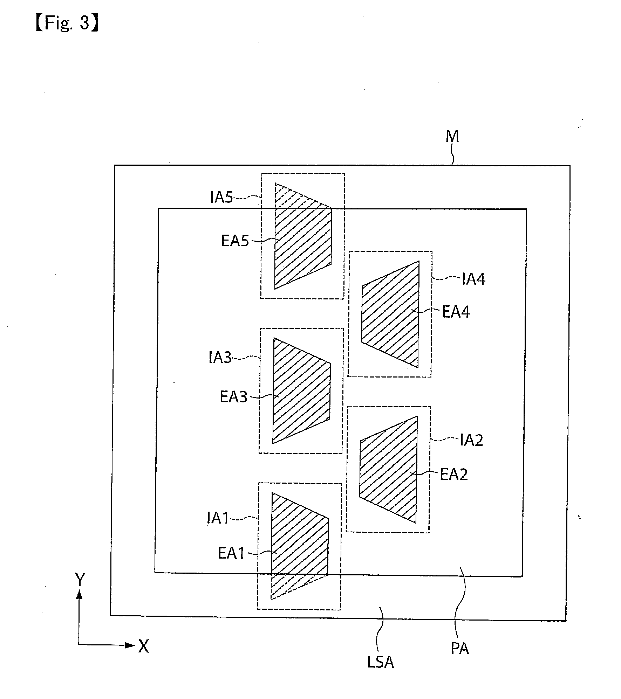

Fig. 3 shows a planar positional relationship between the mask M and the field areas EA1 to EA5 brought about by the partial projection optical systems PL1 to PL5. The pattern PA is formed on the mask M. A light shielding portion LSA is provided to surround the area of the pattern PA. The illumination optical systems 11 to 15 uniformly illuminate illumination areas IA1 to IA5 surrounded by broken lines in the drawing respectively. The trapezoidal field areas EA1 to EA5, which are brought about by unillustrated field diaphragms provided in the partial projection optical systems PL1 to PL5 as described above, are arranged in the illumination areas IA1 to IA5, respectively. The upper sides (short sides of the pairs of parallel sides) of the field areas EA1, EA3, EA5 are arranged so that they are opposite to or facing the upper sides of the field areas EA2, EA4. In this case, the trapezoidal field areas EA1 to EA5 are arranged so that the total sum of the widths of the field areas EA1 to EA5, which is taken in the X direction, i.e., in the scanning direction, is always constant at every position in the Y direction, for the following reason. That is, it is intended to obtain a uniform exposure amount distribution over the entire surface of the exposure area on the plate P when the exposure is performed while moving the plate P.

The first exposure areas and the second exposure areas, which are disposed on the plate P, are defined while being separated from each other in the X direction. Therefore, the pattern, which extends in the Y direction, is subjected to the exposure while being divided temporally and spatially such that the pattern is firstly subjected to the exposure with the islandish first exposure areas which are spatially separated from each other; and then the pattern is subjected to the exposure with the second exposure areas which fill the spaces between the first exposure areas, after allowing a certain period of time to elapse.

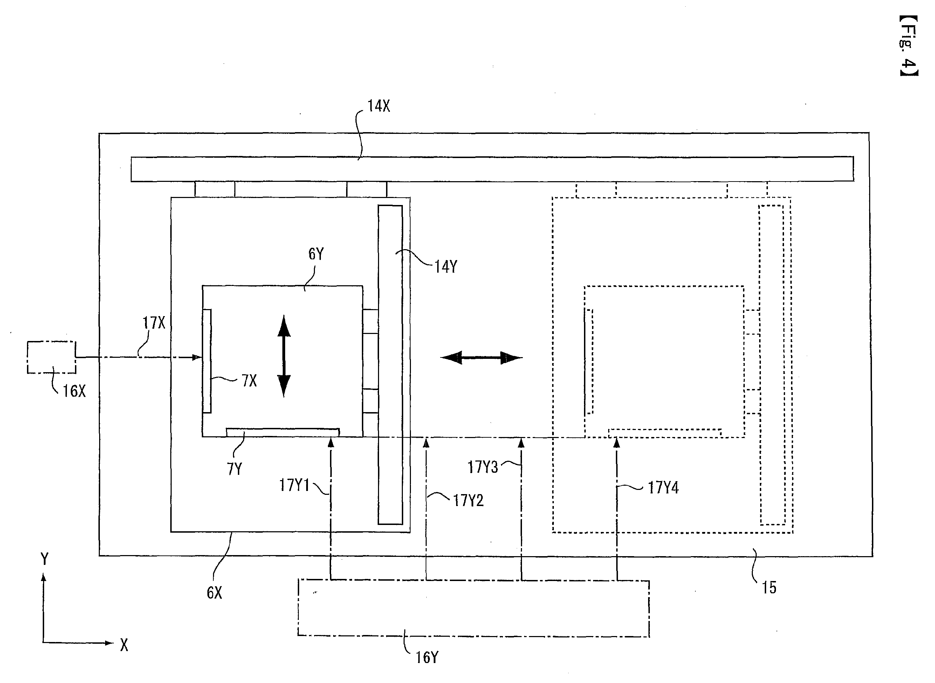

As shown in Figs. 1 and 4, the plate P is held on a plate stage 6 which serves as the substrate stage. The plate stage 6 has a stroke which is long in the X direction (scanning direction). The plate stage 6 is driven by a plate stage driving section 14 under the control of a stage control section 12 to two-dimensionally position the plate P in the plane perpendicular to the optical axis AX of the projection optical system PL and the plate stage 6 moves at a predetermined velocity in the X direction during the exposure.

The plate stage 6 includes an X stage 6X which is provided to move in the X direction on a base (surface plate) 15 and a Y stage 6Y which is provided to move in the Y direction on the X stage 6X. Although not shown, those provided on the Y stage 6 are, for example, a Z stage which positions the plate P in the direction (Z axis) parallel to the optical axis AX of the projection optical system PL and which adjusts the inclination of the plate P with respect to the XY plane, and a stage (not shown) which finely rotates the plate P. The plate P is attracted and held by an unillustrated plate holder which is supported on the stage. The plate stage driving section 14 includes an X direction driving section 14X and a Y direction driving section 14Y which are constructed of, for example, linear motors respectively. The X stage 6X is moved in the X direction by the X direction driving section 14X, and the Y stage 6Y is moved in the Y direction by the Y direction driving section 14Y.

As shown in Fig. 1, a movement mirror 7 is attached to the upper surface of the plate stage 6. A stage position measuring apparatus 16 (or stage position measuring apparatus device 16), which is provided with a laser interferometer, is arranged at a position opposite to or facing the mirror surface of the movement mirror 7. As shown in Fig. 4, the movement mirror 7 is constructed of a plane mirror (movement mirror) 7X which has a reflecting surface perpendicular to the X axis and a plane mirror (movement mirror) 7Y which has a reflecting surface perpendicular to the Y axis. The movement mirror 7X is fixed in the Y direction at an end edge in the -X direction on the Y stage 6Y, and the movement mirror 7Y is fixed in the X direction at an end edge in the -Y direction on the Y stage 6Y.

As shown in Fig. 4, the stage position measuring device 16 includes an X interferometer unit 16X and a Y interferometer unit 16Y having laser interferometers. The X interferometer unit 16X radiates a laser beam (detection light or detection light beam) on a single position measuring axis 17X along with the X axis with respect to the movement mirror 7X. The Y interferometer unit 16Y radiates laser beams (detection lights) on a plurality of (four in this embodiment) position measuring axes 17Y1 to 17Y4 along with the Y axis with respect to the movement mirror 7Y. The arrangement intervals in the X axis direction of the plurality of position measuring axes 17Y1 to 17Y4 of the Y interferometer unit 16Y are set to be intervals narrower than the size (size in the X axis direction) of the reflecting surface of the movement mirror 7Y. Among the respective position measuring axes 17Y1 to 17Y4 of the Y interferometer unit 16Y, the interval between the position measuring axes 17Y1 and 17Y3 disposed in the odd-numbered columns and the interval between the position measuring axes 17Y2 and 17Y4 disposed in the even-numbered columns are set to be such intervals that the respective detection lights thereof are not simultaneously irradiated (radiated) onto the movement mirror 7Y. The X coordinate of the plate stage 6 (Y stage 6Y) is measured by the X interferometer unit 16X, and the Y coordinate of the plate stage 6 (Y stage 6Y) is measured by the Y interferometer unit 16Y. Obtained measured values are supplied to the stage control section 12. The Y interferometer unit 16Y will be described in detail later on.

The two-dimensional coordinates of the plate stage 6 are always detected at a predetermined resolution by the stage position measuring device 16. A position measurement signal, which indicates the measured values (X coordinate, Y coordinate) measured by the stage position measuring device 16, is outputted to the stage control section 12; and the stage control section 12 controls the movement of the plate stage 6 by driving the plate stage driving section 14 in accordance with a control signal from the main controller 10 while making reference to the measurement result obtained by the stage position measuring device 16.

As shown in Fig. 1, a reference plate 8, which is formed with a plurality of types of indexes or reference marks, is attached to one end of the upper surface of the plate stage 6. A spatial image sensor 9 for measuring the spatial image is provided under or below the reference plate 8. The spatial image sensor 9 is provided with, for example, CCD (Charge Coupled Device). The spatial image sensor 9 photographs or images the spatial image via an aperture formed as one of the reference marks on the reference plate 8, and the spatial image sensor 9 outputs an image signal thereof to a apparatus-body control section 11 (control section of the body of the exposure apparatus).

The apparatus-body control section 11 performs the image processing including, for example, the contrast adjustment, the edge extraction, and the pattern recognition for the spatial image outputted from the spatial image sensor 9 to calculate the position of the position measuring mark formed on the mask M and calculate the calibration value in order to correct the aberration generated in the projection optical system PL. The apparatus-body control section 11 determines the deviation of rotation of the mask M and the position of the mask M arranged on the mask stage 5 based on the calculated values to output, to the stage control section 12, a control signal for correcting the deviation of rotation of the mask M and a control signal for performing, for example, the relative positional adjustment between the mask stage 5 and the plate stage 6.

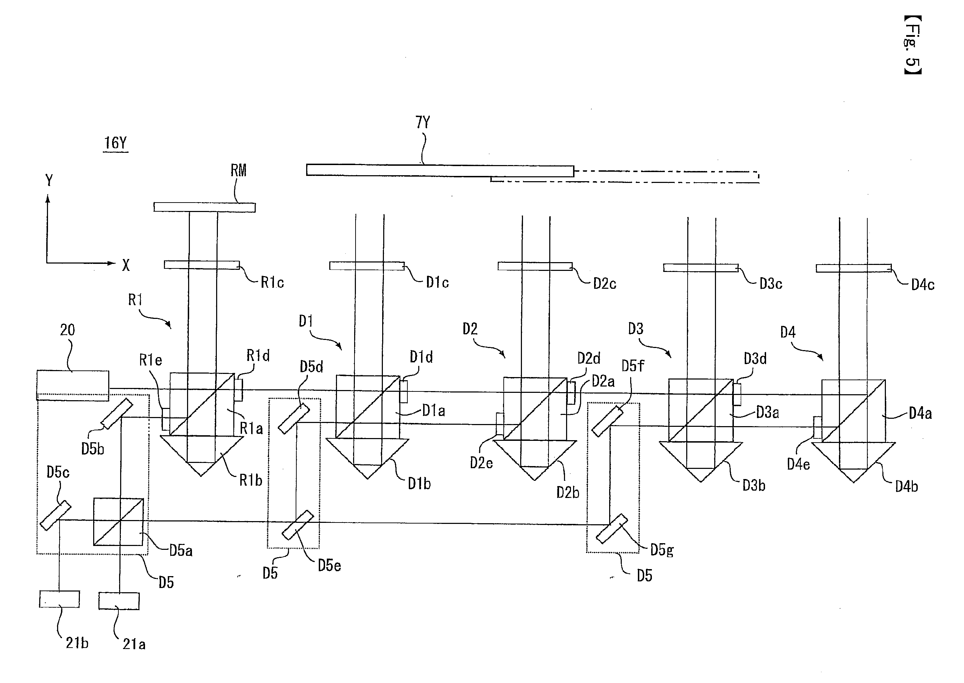

Next, the stage position measuring device 16 (Y interferometer unit 16Y) will be explained in detail with reference to Fig. 5. Fig. 5 shows a plan view illustrating a construction of the stage position measuring device according to the first embodiment of the present invention. The Y interferometer unit 16Y is a position measuring apparatus or device which measures the position (coordinate value) in the Y direction over the entire region in the X direction of the plate stage 6 which has the long stroke in the X direction. The Y interferometer unit 16Y includes a single laser light source (for example, He-Ne laser) 20, and a pair of detecting sections 21a, 21b. Each of the detecting sections 21a, 21b has a light-receiving section provided with a light-detecting element.

The Y interferometer unit 16Y further includes a reference-light unit R1, a first detection-light unit D1, a second detection-light unit D2, a third detection-light unit D3, a fourth detection-light unit D4, and a reflected-light unit D5 each of which includes a plurality of optical elements. In this construction, a first position measuring module is constructed by using the first detection-light unit D1 and the third detection-light unit D3 which are provided corresponding to the position measuring axes 17Y1, 17Y3 disposed in the odd-numbered columns, the reference-light unit R1, and the detecting section 21a. A second position measuring module is constructed by using the second detection-light unit D2 and the fourth detection-light unit D4 which are provided corresponding to the position measuring axes 17Y2, 17Y4 disposed in the even-numbered columns, the reference-light unit R1, and the detecting section 21b.

The reference-light unit R1 is provided with a polarizing beam splitter R1a, a corner cube R1b, 1/4 wavelength plates R1c, R1d, R1e, and a fixed mirror (reflecting mirror) RM. The first detection-light unit D1 is provided with a polarizing beam splitter D1a, a corner cube D1b, and 1/4 wavelength plates D1c, D1d; and the second detection-light unit D2 is provided with a polarizing beam splitter D2a, a corner cube D2b, 1/4 wavelength plates D2c, D2d, and a 1/2 wavelength plate D2e. The third detection-light unit D3 is provided with a polarizing beam splitter D3a, a corner cube D3b, a 1/4 wavelength plate D3c, and a 1/2 wavelength plate D3d; and the fourth detection-light unit D4 is provided with a polarizing beam splitter D4a, a corner cube D4b, a 1/4 wavelength plate D4c, and a 1/2 wavelength plate D4e. The reflected-light unit D5 is provided with a polarizing beam splitter D5a, and mirrors D5b, D5c, D5d, D5e, D5f, D5g. The mirrors D5b, D5c, D5d, D5f, D5g are total reflection mirrors, and the mirror D5e is a half mirror for combining optical paths.

The laser beam, which is radiated in the +X direction from the laser light source 20, comes into the polarizing beam splitter R1a of the reference-light unit R1. The laser beam is subjected to the polarization splitting in accordance with the polarized light components thereof which are radiated in the +X direction and the +Y direction. The P-polarized light component, which is transmitted through the polarizing beam splitter R1a, is converted into the circularly polarized light (circularly polarized light beam) by the 1/4 wavelength plate Rld, and then is supplied to the first detection-light unit D1 arranged on the downstream side.

The S-polarized light component, which is reflected in the +Y direction by the polarizing beam splitter R1a, is converted into the circularly polarized light by the 1/4 wavelength plate R1c, and is irradiated as the reference light or reference light beam (reference illumination light or reference illumination light beam) onto the fixed mirror RM. The reflected light, which is reflected in the -Y direction by the fixed mirror RM, is converted by the 1/4 wavelength plate R1c into the linearly polarized light (linearly polarized light beam) again. The light, exiting in the -Y direction from the 1/4 wavelength plate R1c, has the polarization plane which is rotated by 90 degrees with respect to the polarization plane of the light coming in the +Y direction into the 1/4 wavelength plate R1c. The fixed mirror RM is attached, for example, to a member which is not moved and provided fixedly and which is, for example, a column for supporting the projection optical system PL. However, the fixed mirror RM may be fixedly provided in the Y interferometer unit 16Y.

The linearly polarized light from the 1/4 wavelength plate R1c comes into the polarizing beam splitter R1a. The light is transmitted through the polarizing beam splitter R1a, and the light is reflected in the +Y direction by the corner cube R1b. The light is transmitted through the polarizing beam splitter R1a again. The light is converted into the circularly polarized light by the 1/4 wavelength plate R1c, and the light is irradiated onto the fixed mirror RM. The reflected light, which is reflected in the -Y direction by the fixed mirror RM, is converted into the linearly polarized light by the 1/4 wavelength plate R1c.

The linearly polarized light from the 1/4 wavelength plate R1c is reflected in the -X direction by the polarizing beam splitter R1a. The light is converted into the circularly polarized light by the 1/4 wavelength plate R1e, and the light is reflected in the -Y direction by the mirror D5b; and the light comes into the polarizing beam splitter D5a, and the light is subjected to the polarization splitting in accordance with the polarized light components thereof which are radiated in the -X direction and the -Y direction. The P-polarized light component, which is transmitted through the polarizing beam splitter D5a in the -Y direction, comes into the detecting section 21a as the reference light. The S-polarized light component, which is reflected by the polarizing beam splitter D5a, is reflected in the -Y direction by the mirror D5c, and the light comes into the detecting section 21b as the reference light.

The circularly polarized light, exiting from the 1/4 wavelength plate R1d of the reference-light unit R1, comes into the polarizing beam splitter D1a of the first detection-light unit D1; and the light is subjected to the polarization splitting in accordance with the polarized light components thereof, and are radiated in the +X direction and the +Y direction. The P-polarized light component, which is transmitted through the polarizing beam splitter D1a, is converted into the circularly polarized light by the 1/4 wavelength plate D1d, and then the light is supplied to the second detection-light unit D2 arranged on the downstream side.

The S-polarized light component, which is reflected in the +Y direction by the polarizing beam splitter D1a, is converted into the circularly polarized light by the 1/4 wavelength plate D1c, and the light is irradiated onto the movement mirror 7Y. The reflected light, which is reflected in the -Y direction by the movement mirror 7Y, is converted into the linearly polarized light by the 1/4 wavelength plate D1c again. The light, exiting in the -Y direction from the 1/4 wavelength plate D1c, has the polarization plane which is rotated by 90 degrees with respect to the polarization plane of the light coming into the 1/4 wavelength plate D1c in the +Y direction.

The linearly polarized light from the 1/4 wavelength plate D1c comes into the polarizing beam splitter D1a; and the light is transmitted through the polarizing beam splitter D1a, and the light is reflected in the +Y direction by the corner cube D1b. The light is transmitted through the polarizing beam splitter D1a; and the light is converted into the circularly polarized light by the 1/4 wavelength plate D1c, and the light is irradiated onto the movement mirror 7Y. The reflected light, which is reflected in the -Y direction by the movement mirror 7Y, is converted into the linearly polarized light by the 1/4 wavelength plate D1c.

The linearly polarized light from the 1/4 wavelength plate D1c is reflected in the -X direction by the polarizing beam splitter D1a; and the light is reflected in the -Y direction by the mirror D5d of the reflected-light unit D5. The light is further reflected in the -X direction by the mirror D5e, and the light is reflected in the -Y direction by the polarizing beam splitter D5a; and the light comes into the detecting section 21a as the first detection light.

The circularly polarized light, exiting from the 1/4 wavelength plate D1d of the first detection-light unit D1, comes into the polarizing beam splitter D2a of the second detection-light unit D2. The light is subjected to the polarization splitting in accordance with the polarized light components thereof, and exit in the +X direction and the +Y direction. The P-polarized light component, which is transmitted through the polarizing beam splitter D2a, is converted into the circularly polarized light by the 1/4 wavelength plate D2d, and then the light is supplied to the third detection-light unit D3 arranged on the downstream side.

The S-polarized light component, which is reflected in the +Y direction by the polarizing beam splitter D2a, is converted into the circularly polarized light by the 1/4 wavelength plate D2c, and the light is irradiated onto the movement mirror 7Y. The reflected light, which is reflected in the -Y direction by the movement mirror 7Y, is converted into the linearly polarized light by the 1/4 wavelength plate D2c again. The light, exiting in the -Y direction from the 1/4 wavelength plate D2c, has the polarization plane which is rotated by 90 degrees with respect to the polarization plane of the light coming into the 1/4 wavelength plate D2c in the +Y direction.

The linearly polarized light from the 1/4 wavelength plate D2c comes into the polarizing beam splitter D2a; and the light is transmitted through the polarizing beam splitter D2a, and the light is reflected in the +Y direction by the corner cube D2b. The light is transmitted through the polarizing beam splitter D2a; and the light is converted into the circularly polarized light by the 1/4 wavelength plate D2c, and the light is irradiated onto the movement mirror 7Y. The reflected light, which is reflected in the -Y direction by the movement mirror 7Y, is converted into the linearly polarized light by the 1/4 wavelength plate D2c.

The linearly polarized light from the 1/4 wavelength plate D2c is reflected in the -X direction by the polarizing beam splitter D2a, and the polarization plane thereof is rotated by 90 degrees by the 1/2 wavelength plate D2e. The light is transmitted through the polarizing beam splitter D1a of the first detection-light unit D1, and the light is reflected in the -Y direction by the mirror D5d. The light is further reflected in the -X direction by the mirror D5e, and the light is transmitted through the polarizing beam splitter D5a. The light is reflected in the -Y direction by the mirror D5c, and the light comes into the detecting section 21b as the second detection light.

The polarized light, exiting from the 1/4 wavelength plate D2d of the second detection-light unit D2, comes into the polarizing beam splitter D3a of the third detection-light unit D3, and the light is subjected to the polarization splitting in accordance with the polarized light components thereof, and exit in the +X direction and the +Y direction. The P-polarized light component, which is transmitted through the polarizing beam splitter D3a, has the polarization plane which is rotated by 90 degrees by the 1/2 wavelength plate D3d, and then the light is supplied to the fourth detection-light unit D4 arranged on the downstream side.

The S-polarized light component, which is reflected in the +Y direction by the polarizing beam splitter D3a, is converted into the circularly polarized light by the 1/4 wavelength plate D3c, and the light is irradiated onto the movement mirror 7Y. The reflected light, which is reflected in the -Y direction by the movement mirror 7Y, is converted into the linearly polarized light by the 1/4 wavelength plate D3c again. The light, exiting in the -Y direction from the 1/4 wavelength plate D3c, has the polarization plane which is rotated by 90 degrees with respect to the polarization plane of the light coming in the +Y direction into the 1/4 wavelength plate D3c.

The linearly polarized light from the 1/4 wavelength plate D3c comes into the polarizing beam splitter D3a; and the light is transmitted through the polarizing beam splitter D3a, and the light is reflected in the +Y direction by the corner cube D3b. The light is transmitted through the polarizing beam splitter D3a; and the light is converted into the circularly polarized light by the 1/4 wavelength plate D3c, and the light is irradiated onto the movement mirror 7Y. The reflected light, which is reflected in the -Y direction by the movement mirror 7Y, is converted into the linearly polarized light by the 1/4 wavelength plate D3c.

The linearly polarized light from the 1/4 wavelength plate D3c is reflected in the -X direction by the polarizing beam splitter D3a, and the light is reflected in the -Y direction by the mirror D5f. The light is further reflected in the -X direction by the mirror D5g, and the light is transmitted through the mirror D5e. The light is reflected in the -Y direction by the polarizing beam splitter D5a, and the light comes into the detecting section 21a as the third detection light.

The linearly polarized light (S-polarized light or S-polarized light beam), exiting from the 1/2 wavelength plate D3d of the third detecting section D3, comes into the polarizing beam splitter D4a of the fourth detection-light unit D4, and the light is reflected in the +Y direction by the polarizing beam splitter D4a. In this case, any other detection-light unit is not provided on the downstream side of the fourth detection-light unit D4. Therefore, the light is converted into the linearly polarized light (S-polarized light or S-polarized beam) by the 1/2 wavelength plate D3d of the third detection-light unit D3. However, when any other detection-light unit is further provided on the downstream side, the following construction is available. That is, a 1/4 wavelength plate is provided in place of the 1/2 wavelength plate D3d, and the P-polarized light component, which is transmitted through the polarizing beam splitter D3a, is converted into the circularly polarized light by the 1/4 wavelength plate; and after that, the light is supplied to the fourth detection-light unit D4.

The light (S-polarized light component), which is reflected in the +Y direction by the polarizing beam splitter D4a, is converted into the circularly polarized light by the 1/4 wavelength plate D4c, and the light is irradiated onto the movement mirror 7Y. The reflected light, which is reflected in the -Y direction by the movement mirror 7Y, is converted into the linearly polarized light by the 1/4 wavelength plate D4c again. The light, exiting in the -Y direction from the 1/4 wavelength plate D4c, has the polarization plane which is rotated by 90 degrees with respect to the polarization plane of the light coming in the +Y direction into the 1/4 wavelength plate D4c.

The linearly polarized light from the 1/4 wavelength plate D4c comes into the polarizing beam splitter D4a; and the light is transmitted through the polarizing beam splitter D4a, and the light is reflected in the +Y direction by the corner cube D4b. The light is transmitted through the polarizing beam splitter D4a; and the light is converted into the circularly polarized light by the 1/4 wavelength plate D4c, and the light is irradiated onto the movement mirror 7Y. The reflected light, which is reflected in the -Y direction by the movement mirror 7Y, is converted into the linearly polarized light by the 1/4 wavelength plate D4c.

The linearly polarized light from the 1/4 wavelength plate D4c is reflected in the -X direction by the polarizing beam splitter D4a, and the polarization plane thereof is rotated by 90 degrees by the 1/2 wavelength plate D4e. The light is transmitted through the polarizing beam splitter D3a of the third detection-light unit D3, and the light is reflected in the -Y direction by the mirror D5f. The light is further reflected in the -X direction by the mirror D5g, and the light is transmitted through the mirror D5e. Further, the light is transmitted through the polarizing beam splitter D5a. The light is reflected in the -Y direction by the mirror D5c, and the light comes into the detecting section 21b as the fourth detection light. When any other detection-light unit is provided on the downstream side of the fourth detection-light unit D4, the mirror D5g is a half mirror for combining the optical paths in the same manner as the mirror D5e.

The first to fourth detection-light units D1 to D4 of the Y interferometer unit 16Y are arranged for the four position measuring axes 17Y1 to 17Y4 shown in Fig. 4 respectively. The position measuring axes 17Y1 to 17Y4 are disposed or arranged so that the detection light is irradiated onto the movement mirror 7Y from at least one of the first to fourth detection-light units D1 to D4 even when the plate stage 6 is positioned at any place included in the entire stroke in the X direction. In this case, the respective position measuring axes 17Y1 to 17Y4 are arranged in a row (aligned) at the intervals narrower than the size in the longitudinal direction of the reflecting surface of the movement mirror 7Y. The respective position measuring axes 17Y1 to 17Y4 are arranged at the intervals slightly narrower than the size in the longitudinal direction (X direction) of the movement mirror 7Y so that the three detection lights are not simultaneously irradiated onto the movement mirror 7Y. Accordingly, the Y interferometer unit 16Y can measure the position, of the plate stage 6, in the Y direction over the entire stroke (entire movement range) in the X direction of the plate stage 6.

The detection lights in the odd-numbered columns, among the detection lights irradiated onto the position measuring axes 17Y1 to 17Y4 by the detection-light units D1 to D4, respectively, i.e., the detection lights radiated from the first detection-light unit D1 and the third detection-light unit D3 provide the reflected lights from the movement mirror 7Y, and the reflected lights are allowed to come into the detecting section 21a. The detecting section 21a detects the interference fringe generated by the interference between the reflected light and the reference light coming into the detecting section 21a simultaneously, to thereby measure the position of the movement mirror 7Y in the Y direction, i.e., the position of the plate stage 6 in the Y direction. The detection lights in the even-numbered columns, among the detection lights irradiated onto the position measuring axes 17Y1 to 17Y4 by the detection-light units D1 to D4, respectively, i.e., the detection lights irradiated from the second detection-light unit D2 and the fourth detection-light unit D4 provide the reflected lights from the movement mirror 7Y, and the reflected lights are allowed to come into the detecting section 21b. The detecting section 21b detects the interference fringes generated by the interference between the reflected lights and the reference light coming into the detecting section 21b simultaneously, to thereby measure the position of the movement mirror 7Y in the Y direction, i.e., the position of the plate stage 6 in the Y direction.

It is possible to distinguish, whether the detection light coming into the detecting section 21a is the detection light provided by the first detection-light unit D1 or the detection light provided by the third detection-light unit D3 or whether the detection light coming into the detecting section 21b is the detection light provided by the second detection-light unit D2 or the detection light provided by the fourth detection-light unit D4, such that the stage control section 12 compares the coordinate value in the X direction of the plate stage 6 detected by the X interferometer unit 16X with the position in the X direction of each of the position measuring axes 17Y1 to 17Y4 of the respective detection-light unit D1 to D4.

For example, when the Y stage 6Y is moved in the +X direction in the state shown in Fig. 4, the measured value, which is measured by the detecting section 21a based on the detection light concerning the position measuring axis 17Y1, is delivered (initially set) by the stage control section 12 as the initial value of the measured value of the detecting section 21b based on the detection light concerning the position measuring axis 17Y2 which in turn radiates the movement mirror 7Y simultaneously with the detection light concerning the position measuring axis 17Y1 in accordance with the movement of the movement mirror 7Y. The same or equivalent procedure is also adopted for the position measuring axes 17Y2 and 17Y3 and the position measuring axes 17Y3 and 17Y4 to be used thereafter. The measured value in relation to the position measuring axis which is disposed on the upstream side, i.e., the measured value of the detecting section which has performed the measurement before the delivery is delivered as the initial value of the measured value in relation to the position measuring axis which is disposed on the downstream side, i.e., the initial value of the measured value of the detecting section which succeeds the measurement after the delivery, for the following reason. That is, the measuring device of this type measures the relative amount of movement from a certain position on the stage to another position. If only the detection light, which suddenly radiates the movement mirror 7Y as in this embodiment, is used, it is impossible to know the stage position at the concerning point in time. When the same or equivalent delivery procedure is repeated in accordance with the movement of the movement mirror 7Y, it is possible to continuously measure the stage position in the Y direction even when the movement mirror 7Y is moved in the X direction by a distance of not less than the size thereof. The same or equivalent procedure is also adopted when the movement mirror 7Y (plate stage 6) is moved in the -X direction.

The measured values, which are obtained by the respective detecting sections 21a, 21b, are supplied to the stage control section 12. The stage control section 12 performs a process of the distinction to know which detection light of those of the respective position measuring axes 17Y1 to 17Y4 is detected as described above, a process of the delivery or transfer of the measured value concerning the detection light on the upstream side as the initial value concerning the detection light on the downstream side, etc. The stage control section 12 controls the movement of the plate stage 6 based on the measured values obtained by the X interferometer unit 16X and the Y interferometer unit 16Y. Control as to which measured value of those of the respective detecting sections 21a, 21b is to be used may be performed based on the position information of the X interferometer unit 16X.

In the first embodiment described above, the unit, which radiates the single axis detection light, has been explained as the X interferometer unit 16X, and the unit, which radiates the multi-axis (four-axis in the above) detection light, has been explained as the Y interferometer unit 16Y. However, any unit, which radiates the multi-axis detection light, may be used as the X interferometer unit in the same manner as the Y interferometer unit 16Y described above.

In the first embodiment described above, the reference-light unit R1 is arranged between the laser light source 20 and the first detection-light unit D1 as shown in Fig. 5. However, there is no limitation to this. For example, the reference-light unit R1 may be arranged between the second detection-light unit D2 and the third detection-light unit D3 as seen in a plan view. When the reference-light unit R1 is arranged between the second detection-light unit D2 and the third detection-light unit D3 as described above, it is possible to mutually decrease the difference in the optical path lengths each between the optical path length of the detection light brought about by one of the first to fourth detection-light units D1 to D4 and the optical path length of the reference light brought about by the reference-light unit R1; and thus it is possible to suppress the difference in the measurement accuracy between the units (difference between the position measuring axes) which would be otherwise caused by the difference in the optical path length.

According to the stage position measuring device concerning the first embodiment described above, even in the case of the stage having the stroke larger than the size of the movement mirror in the longitudinal direction, it is possible to measure the position over the entire region of the stage. Therefore, even when the stage is large-sized in order to move the large-sized plate (substrate), it is possible to easily respond to such a situation without enlarging the size of the movement mirror in the longitudinal direction. Further, it is possible to use the small-sized movement mirror which is inexpensive and highly accurate. Therefore, it is possible to realize the light weight and the low cost of the stage.

Additionally, according to the first embodiment described above, the laser beam from the laser light source 20 is distributed to the first to fourth detection-light units D1 to D4 to effect the irradiation as the detection lights on the plurality of position measuring axes 17Y1 to 17Y4. Further, the reflected lights, which are included in the reflected lights of the respective detection lights reflected by the movement mirror 7Y and which relate to the first and third detection-light units D1, D3 in the odd-numbered columns constructing the first position measuring module, are detected by the detecting section 21a; and the reflected lights, which relate to the second and fourth detection-light units D2, D4 in the even-numbered columns for constructing the second position measuring module, are detected by the detecting section 21b. Therefore, the four detection lights (position measuring axes 17Y1 to 17Y4) can be detected by the two detecting sections, thereby simplifying the construction of the Y interferometer unit 16Y, and making it possible to further decrease the cost.

Further, even in a case that the stroke of the stage is further enlarged, it is possible to respond to such a situation by adding an unit same as the first detection-light unit D1 as the unit constructing the first position measuring module in the case of the odd-numbered column, and adding an unit same as the second detection-light unit D2 as the unit constructing the second position measuring module in the case of the even-numbered column. Thus, it is unnecessary to increase the number of the detecting sections. Therefore, it is possible to flexibly respond to the enlargement of the stroke of the stage easily at the low cost. In this way, the present invention is effective for the large-sized substrate, especially in the case of the exposure apparatus which exposes the pattern and the stage apparatus on which the substrate, having a substrate outer diameter exceeding 500 mm, is placed.

### Second Embodiment

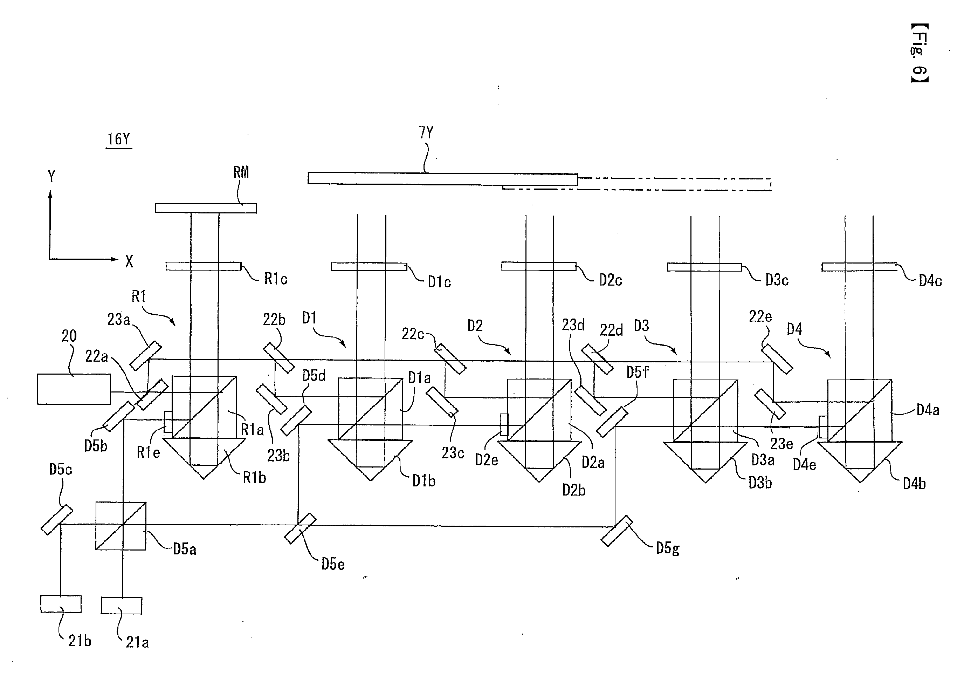

Next, a second embodiment of the present invention will be explained with reference to Fig. 6. In the construction shown in Fig. 5, the laser beam, which is radiated from the laser light source 20, is subjected to the polarization splitting at a ratio of 50% by each of the polarizing beam splitters R1a, D1a to D3a, and the laser beam is distributed to the reference-light unit R1 and the first to fourth detection-light units D1 to D4. Therefore, the energy (power, light amount) of the detection light is lowered as the light progressively travels to the detection-light units disposed on the more downstream side. In the second embodiment of the present invention, this point is improved so that the powers of the reference light irradiated from the reference-light unit R1 and the respective detection lights irradiated from the first to fourth detection-light units D1 to D4 are made to be mutually uniform or equivalent. The constitutive parts or components, which are substantially same as those shown in Fig. 5, are designated by the same reference numerals, and any explanation therefor will be omitted.

With reference to Fig. 6, the laser beam, which is radiated from the laser light source 20, comes into a partial transmission mirror 22a which reflects 80% of the incident light (incident light beam) and through which 20 % of the incident light is transmitted. The transmitted light comes into the polarizing beam splitter R1a of the reference-light unit R1. The reflected light, which is reflected by the partial transmission mirror 22a, is reflected by a total reflection mirror 23a, and the light comes into a partial transmission mirror 22b which reflects 25 % of the incident light and through which 75 % of the incident light is transmitted. The reflected light, which is reflected by the partial transmission mirror 22b, is reflected by a total reflection mirror 23b, and the light is supplied to the polarizing beam splitter D1a of the first detection-light unit D1. The transmitted light, which is transmitted through the partial transmission mirror 22b, comes into a partial transmission mirror 22c which reflects 33 % of the incident light and through which 67 % of the incident light is transmitted.

The reflected light, which is reflected by the partial transmission mirror 22c, is reflected by a total reflection mirror 23c, and the light is supplied to the polarizing beam splitter D2a of the second detection-light unit D2. The transmitted light, which is transmitted through the partial transmission mirror 22c, comes into a partial transmission mirror 22d which reflects 50 % of the incident light and through which 50 % of the incident light is transmitted. The reflected light, which is reflected by the partial transmission mirror 22d, is reflected by a total reflection mirror 23d, and the light is supplied to the polarizing beam splitter D3a of the third detection-light unit D3. The transmitted light, which is transmitted through the partial transmission mirror 22d, is reflected by each of total reflection mirrors 22e, 23e, and the light is supplied to the polarizing beam splitter D4a of the fourth detection-light unit D4.

By adopting the construction as described above, it is possible to use every 20% of the radiated light (irradiated light or radiated light beam) exiting (radiated) from the laser light source 20 as the reference light and each of the detection lights. In a case that a detection-light unit is added, the transmittances of the partial transmission mirrors 22a to 22d and an additional partial transmission mirror are appropriately set depending on the number of the detection-light units. Accordingly, it is possible to uniformize the powers of the reference light and the respective detection lights. It goes without saying that the light amount is adjusted by changing the transmittance of the partial transmission mirror depending on the number of the constitutive detection-light units. It is also allowable that all of the reference light and the respective detection lights are not uniform or equivalent provided that the light amount is within a range in which the detection can be stably performed in each of the detecting sections 21a, 21b.

### Third Embodiment

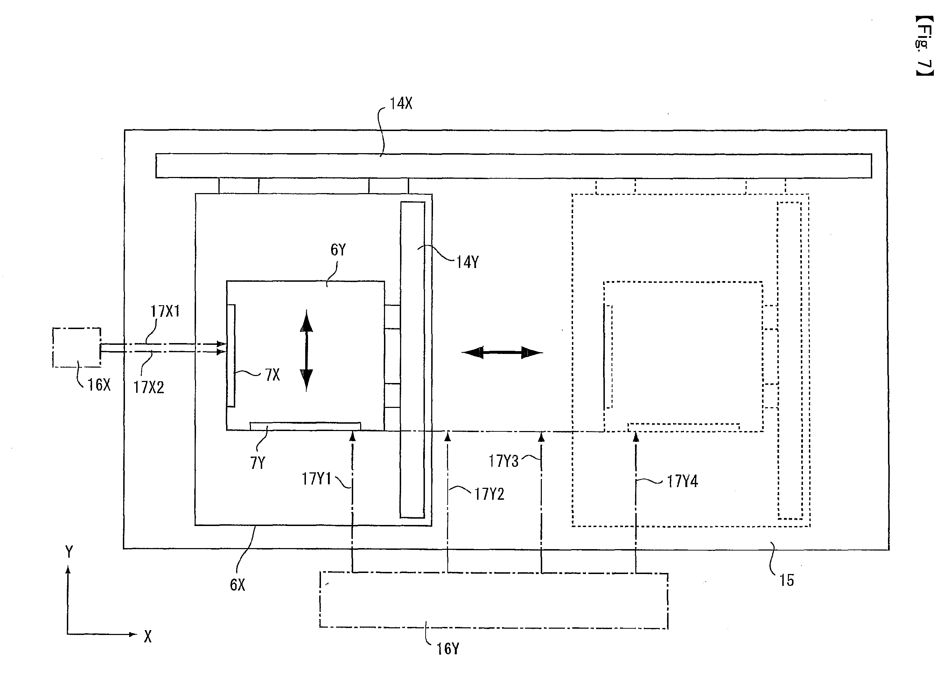

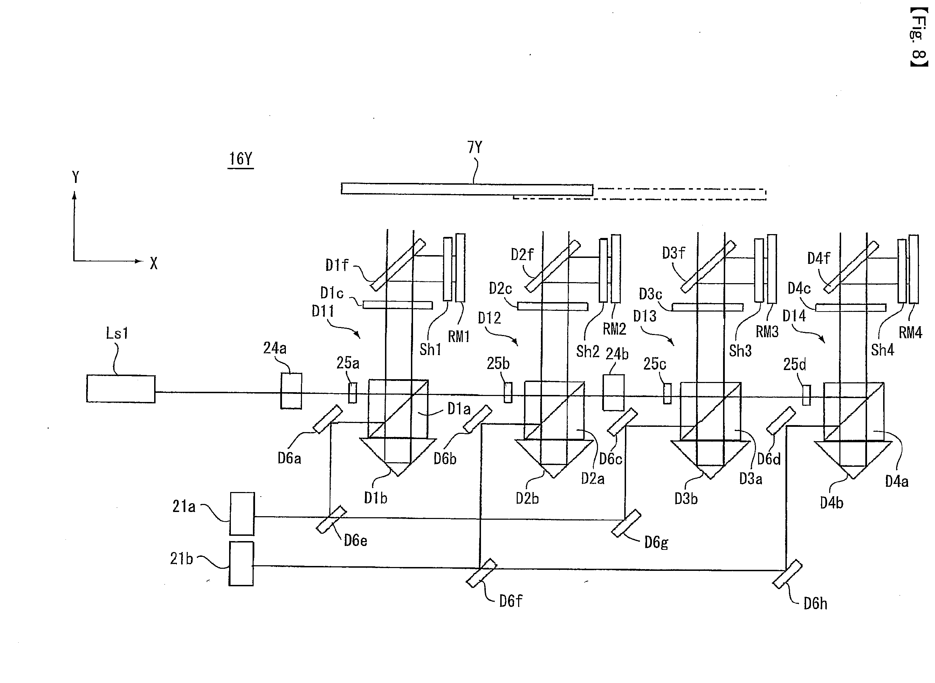

Next, a third embodiment of the present invention will be explained with reference to Figs. 7 and 8.

In the first embodiment described above, as shown in Fig. 4, the unit, which radiates the laser beam (detection light) on the single position measuring axis 17X along with the X axis, has been explained as the X interferometer unit 16X. On the other hand, in the third embodiment, as shown in Fig. 7, a unit, which radiates a laser beam (detection light) on a position measuring axis 17X2 adjacent to a position measuring axis 17X1 in addition to the position measuring axis 17X1 corresponding to the position measuring axis 17X shown in Fig. 4, is used as the X interferometer unit 16X.

The added position measuring axis 17X2 is provided in order to detect the fine angle of rotation about the Z axis of the Y stage 6Y. The detected fine angle of rotation of the Y stage 6Y is supplied to the stage control section 12, and is used to retain the Y stage 6Y at an appropriate posture and is used to set the initial value upon the delivery or transfer of the initial value between the position measuring axes as described later on.

The X interferometer unit 16X shown in Fig. 7 may be also adopted for the first and second embodiments described above as well as a fourth embodiment described later on so that the fine angle of rotation about the Z axis of the Y stage 6Y may be detected to perform the posture control and the delivery process.

In the third embodiment, the Y interferometer unit 16Y is constructed as shown in Fig. 8. In the first and second embodiments described above, one reference-light unit R1 is provided for the first to fourth detection-light units D1 to D4, and the reference light, which is reflected by the fixed mirror RM, is distributed to the detecting section 21a and the detecting section 21b. On the other hand, the third embodiment differs in that reference-light units are integrally provided respectively for first to fourth detection-light units D11 to D14 which are provided in place of the first to fourth detection-light units D1 to D4. This construction will be explained in detail below. The constitutive components or parts, which are the same as those shown in Figs. 5 and 6, are designated by the same reference numerals, any explanation therefor will be appropriately omitted.

The Y interferometer unit 16Y is a position measuring apparatus or device which measures the position (coordinate value) in the Y direction over the entire region of the stroke in the X direction of the plate stage 6 in the same manner as in the first or second embodiment described above. The Y interferometer unit 16Y includes a laser light source (for example, He-Ne laser) Ls1 which outputs (radiates) the linearly polarized light and a pair of detecting sections 21a, 21b. The Y interferometer unit 16Y further includes the first to fourth detection-light units D11 to D14 and a reflected-light unit each of which includes a plurality of optical elements. In this case, a first position measuring module is constructed by using the detecting section 21a and the first and third detection-light units D11, D13 provided corresponding to the position measuring axes 17Y1, 17Y3 disposed in the odd-numbered columns, and a second position measuring module is constructed by using the detecting section 21b and the second and fourth detection-light units D12, D14 provided corresponding to the position measuring axes 17Y2, 17Y4 disposed in the even-numbered columns.

The first detection-light unit D11 includes a polarizing beam splitter D1a, a corner cube D1b, a 1/4 wavelength plate D1c, a half mirror D1f, a shutter Sh1, and a fixed mirror RM1. The second detection-light unit D12 includes a polarizing beam splitter D2a, a corner cube D2b, a 1/4 wavelength plate D2c, a half mirror D2f, a shutter Sh2, and a fixed mirror RM2. The third detection-light unit D13 includes a polarizing beam splitter D3a, a corner cube D3b, a 1/4 wavelength plate D3c, a half mirror D3f, a shutter Sh3, and a fixed mirror RM3. The fourth detection-light unit D14 includes a polarizing beam splitter D4a, a corner cube D4b, a 1/4 wavelength plate D4c, a half mirror D4f, a shutter Sh4, and a fixed mirror RM4. The reflected-light unit includes mirrors D6a to D6h. The mirrors D6a, D6b, D6c, D6d, D6g, D6h are total reflection mirrors, and the mirrors D6e, D6f are half mirrors to serve as optical path combining elements. The shutters Sh1 to Sh4 serve as selective irradiation mechanisms each of which selectively opens/shuts off (closes) the optical path for the reference light in accordance with the operation thereof to thereby selectively perform the irradiation/non-irradiation of the light with respect to one of the fixed mirrors RM1 to RM4. The first to fourth detection-light units D11 to D14 also serve as the reference-light units respectively as described later on.

1/2 wavelength plates 25a to 25d, each of which serves as a light amount adjusting mechanism, is arranged on the upstream side (on the side of the laser light source) of one of the polarizing beam splitters D1a to D4a. Frequency modulators (for example, AOM: Acousto-Optic Modulators) 24a, 24b are arranged on the further upstream side of the 1/2 wavelength plate 25a and on the further upstream side of the 1/2 wavelength plate 25c respectively. Each of the frequency modulators 24a, 24b changes (shifts) the frequency of the light to be transmitted by a predetermined amount. In this case, the two frequency modulators 24a, 24b are provided. However, the frequency modulator 24a may be omitted, and only the frequency modulator 24b may be provided. The reason, why the frequency modulators 24a, 24b are provided as described above, is that the difference is generated in the frequency between the detection light and the reference light so that the heterodyne detection can be performed in each of the detecting sections 21a, 21b.

The laser beam, which is the linearly polarized light radiated in the +X direction from the laser light source Ls1, has the frequency which is shifted by a predetermined amount by the frequency modulator 24a; and the polarization plane of the laser beam is rotated by an required angle by the 1/2 wavelength plate 25a, then the laser beam comes into the polarizing beam splitter D1a of the first detection-light unit D11. The angle of rotation of the polarization plane, which is brought about by the 1/2 wavelength plate 25a, is set so that 25 % of the laser beam is reflected and 75 % of the laser beam is transmitted when the laser beam is subjected to the polarization splitting depending on the angle of the polarization plane by the polarizing beam splitter D1a. The laser light source Ls1 may be rotated about the optical axis, instead of rotating the 1/2 wavelength plate 25a. In this case, it is also possible to omit the arrangement of the 1/2 wavelength plate 25a.

The S-polarized light component reflected in the +Y direction by the polarizing beam splitter D1a is converted into the circularly polarized light by the 1/4 wavelength plate D1c, and the light comes into the half mirror D1f. The light transmitted through the half mirror D1f is irradiated as the detection light onto the movement mirror 7Y; and the light is reflected in the -Y direction by the movement mirror 7Y, and the light is transmitted through the half mirror D1f. Then, the light is converted into the linearly polarized light by the 1/4 wavelength plate D1c again. The light, exiting in the -Y direction from the 1/4 wavelength plate D1c, has the polarization plane which is rotated by 90 degrees with respect to the polarization plane of the light coming the +Y direction into the 1/4 wavelength plate D1c.

The light exiting in the -Y direction from the 1/4 wavelength plate D1c is transmitted through the polarizing beam splitter D1a, and the light is reflected in the +Y direction by the corner cube D1b; and the light is transmitted through the polarizing beam splitter D1a again. Then, the light is converted into the circularly polarized light by the 1/4 wavelength plate D1c, and the light comes into the half mirror D1f. The light transmitted through the half mirror D1f is irradiated as the detection light onto the movement mirror 7Y again, and the light is reflected in the -Y direction by the movement mirror 7Y; and the light is transmitted through the half mirror D1f, and the light is converted into the linearly polarized light by the 1/4 wavelength plate D1c again.

The light coming from the 1/4 wavelength plate D1c is reflected in the -X direction by the polarizing beam splitter D1a, and the light is reflected in the -Y direction by the mirror D6a; and the light is further reflected in the -X direction by the mirror D6e, and the light comes into the detecting section 21a as the first detection light.

On the other hand, the light reflected in the +X direction by the half mirror D1f is irradiated as the reference light onto the fixed mirror RM1 when the shutter Sh1 is open; and the light is reflected in the -X direction by the fixed mirror RM1. The light is reflected in the -Y direction by the half mirror D1f, and the light is converted into the linearly polarized light by the 1/4 wavelength plate D1c again.

The light from the 1/4 wavelength plate D1c is transmitted through the polarizing beam splitter D1a; and the light is reflected in the +Y direction by the corner cube D1b, and the light is transmitted through the polarizing beam splitter D1a again. The light is converted into the circularly polarized light by the 1/4 wavelength plate D1c, and the light comes into the half mirror D1f. The light reflected by the half mirror D1f is irradiated as the reference light onto the fixed mirror RM1 again when the shutter Sh1 is open; and the light is reflected in the -X direction by the fixed mirror RM1. The light is reflected by the half mirror D1f, and the light is converted into the linearly polarized light by the 1/4 wavelength plate D1c again.

The light from the 1/4 wavelength plate D1c is reflected in the -X direction by the polarizing beam splitter D1a, and the light is reflected in the -Y direction by the mirror D6a. The light is further reflected in the -X direction by the mirror D6e, and the light comes into the detecting section 21a as the first reference light.

Further, the P-polarized light component, which is transmitted through the polarizing beam splitter D1a, has the polarization plane which is rotated by an required angle by the 1/2 wavelength plate 25b, and comes into the polarizing beam splitter D2a of the second detection-light unit D12. The angle of rotation of the polarization plane, which is brought about by the 1/2 wavelength plate 25b, is set so that 33 % of the laser beam is reflected and 67 % of the laser beam is transmitted when the laser beam is subjected to the polarization splitting depending on the angle of the polarization plane by the polarizing beam splitter D2a.

A part of the S-polarized light component, which is reflected in the +Y direction by the polarizing beam splitter D2a, is irradiated as the detection light onto the movement mirror 7Y twice via the 1/4 wavelength plate D2c, the half mirror D2f, the polarizing beam splitter D2a, and the corner cube D2b, in the same manner as the S-polarized light component reflected by the polarizing beam splitter D1a. The light, which is reflected for the second time by the movement mirror 7Y, is transmitted through the half mirror D2f, and the light is converted into the linearly polarized light by the 1/4 wavelength plate D2c; and the light is reflected in the -X direction by the polarizing beam splitter D2a, and the light is reflected in the -Y direction by the mirror D6b. The light is further reflected in the -X direction by the mirror D6f, and the light comes into the detecting section 21b as the second detection light.

The light, which is reflected in the +X direction by the half mirror D2f and which is included in the S-polarized light component reflected by the polarizing beam splitter D2a, is irradiated as the reference light onto the fixed mirror RM2 when the shutter Sh2 is open. After that, the light is irradiated as the reference light onto the fixed mirror RM2 again via the half mirror D2f, the 1/4 wavelength plate D2c, the polarizing beam splitter D2a, and the corner cube D2b in the same manner as the light reflected by the half mirror D1f. The light, which is reflected for the second time by the fixed mirror RM2, is reflected by the half mirror D2f, and the light is converted into the linearly polarized light by the 1/4 wavelength plate D2c; and the light is reflected in the -X direction by the polarizing beam splitter D2a, and the light is reflected in the -Y direction by the mirror D6b. The light is further reflected in the -X direction by the mirror D6f, and the light comes into the detecting section 21b as the second reference light.

Further, the P-polarized light component transmitted through the polarizing beam splitter D2a has the frequency which is shifted by a predetermined amount by the frequency modulator 24b; the polarization plane of the light is rotated by a required angle by the 1/2 wavelength plate 25c, and comes into the polarizing beam splitter D3a of the third detection-light unit D13. The angle of rotation of the polarization plane, which is brought about by the 1/2 wavelength plate 25c, is set so that 50 % of the light is reflected and 50 % of the light is transmitted when the laser beam is subjected to the polarization splitting depending on the angle of the polarization plane by the polarizing beam splitter D3a. The frequency shift amount, which is brought about by the frequency modulator 24b, is set to an amount different from the frequency shift amount which is brought about by the frequency modulator 24a.

A part of the S-polarized light component, which is reflected in the +Y direction by the polarizing beam splitter D3a, is radiated as the detection light onto the movement mirror 7Y twice via the 1/4 wavelength plate D3c, the half mirror D3f, the polarizing beam splitter D3a, and the corner cube D3b, in the same manner as the S-polarized light component reflected by the polarizing beam splitter D1a. The light, which is reflected for the second time by the movement mirror 7Y, is transmitted through the half mirror D3f, and the light is converted into the linearly polarized light by the 1/4 wavelength plate D3c; and the light is reflected in the -X direction by the polarizing beam splitter D3a, and the light is reflected in the -Y direction by the mirror D6c; and the light is further reflected in the -X direction by the mirror D6g. The light is transmitted through the mirror D6e, and the light comes into the detecting section 21a as the third detection light.

The light, which is reflected in the +X direction by the half mirror D3f and which is included in the S-polarized light component reflected by the polarizing beam splitter D3a, is irradiated as the reference light onto the fixed mirror RM3 when the shutter Sh3 is open. After that, the light is irradiated as the reference light onto the fixed mirror RM3 again via the half mirror D3f, the 1/4 wavelength plate D3c, the polarizing beam splitter D3a, and the corner cube D3b in the same manner as the light reflected by the half mirror D1f. The light, which is reflected for the second time by the fixed mirror RM3, is reflected by the half mirror D3f, and the light is converted into the linearly polarized light by the 1/4 wavelength plate D3c; and the light is reflected in the -X direction by the polarizing beam splitter D3a, and the light is reflected by the mirror D6c. The light is further reflected in the -X direction by the mirror D6g. Further, the light is transmitted through the mirror D6e, and the light comes into the detecting section 21a as the third reference light.

Further, the P-polarized light component, which is transmitted through the polarizing beam splitter D3a, has the polarization plane which is rotated by a required angle by the 1/2 wavelength plate 25d; and the light comes into the polarizing beam splitter D4a of the fourth detection-light unit D14. The angle of rotation of the polarization plane, which is brought about by the 1/2 wavelength plate 25d, is set so that 100 % of the light coming into the polarizing beam splitter D4a is reflected.

A part of the S-polarized light component, which is reflected in the +Y direction by the polarizing beam splitter D4a, is irradiated as the detection light onto the movement mirror 7Y twice via the 1/4 wavelength plate D4c, the half mirror D4f, the polarizing beam splitter D4a, and the corner cube D4b, in the same manner as the S-polarized light component reflected by the polarizing beam splitter D1a. The light, which is reflected for the second time by the movement mirror 7Y, is transmitted through the half mirror D4f, and the light is converted into the linearly polarized light by the 1/4 wavelength plate D4c; and the light is reflected in the -X direction by the polarizing beam splitter D4a, and the light is reflected in the -Y direction by the mirror D6d. The light is further reflected in the -X direction by the mirror D6h, is transmitted through the mirror D6f, and the light comes into the detecting section 21b as the fourth detection light.

The light, which is reflected in the +X direction by the half mirror D4f and which is included in the S-polarized light component reflected by the polarizing beam splitter D4a, is irradiated as the reference light onto the fixed mirror RM4 when the shutter Sh4 is open. After that, the light is irradiated as the reference light onto the fixed mirror RM4 again via the half mirror D4f, the 1/4 wavelength plate D4c, the polarizing beam splitter D4a, and the corner cube D4b in the same manner as the light reflected by the half mirror D1f. The light, which is reflected for the second time by the fixed mirror RM4, is reflected by the half mirror D4f, and the light is converted into the linearly polarized light by the 1/4 wavelength plate D4c; and the light is reflected in the -X direction by the polarizing beam splitter D4a, and the light is reflected in the -Y direction by the mirror D6d. The light is further reflected in the -X direction by the mirror D6h; and the light is transmitted through the mirror D6f, and the light comes into the detecting section 21b as the fourth reference light.

When any other detection-light unit is provided on the downstream side of the fourth detection-light unit D14 (on the side opposite to the laser light source), the mirror D6g and the mirror D6h are half mirrors as optical path combining elements in the same manner as the mirror D6e or the mirror D6f. Further, the branching light amount ratios for the first to fourth detection-light units D11 to D14, which are set by the 1/2 wavelength plates 25a to 25d, are appropriately changed depending on the number of unit or units of the additional detection-light unit or units.

The operations (opening or closing) of the shutters Sh1 to Sh4 of the respective detection-light units D11 to D14 are controlled by the stage control section 12 depending on the position in the X axis direction of the plate stage 6 (Y stage 6Y). Specifically, the stage control section 12 appropriately distinguishes the detection-light unit which radiates the detection light onto the movement mirror 7Y and the detection-light unit which does not radiate the detection light onto the movement mirror 7Y, based on the measured value obtained by the X interferometer unit 16X. The stage control section 12 performs the control as follows. That is, the optical path for the reference light is shut off by closing the shutter of the detection-light unit which irradiates the detection light onto the movement mirror 7Y, and the optical path for the reference light is opened by opening the shutter of the detection-light unit which does not irradiate the detection light onto the movement mirror 7Y. For example, when it is judged that the Y stage 6Y is at a position at which the detection light provided by the first detection-light unit D11 is irradiated onto the movement mirror 7Y, then the stage control section 12 shuts off or closes the shutter Sh1 of the first detection-light unit D11, and the stage control section 12 opens the shutter Sh3 of the third detection-light unit D13 which does not irradiate the detection light onto the movement mirror 7Y. Similarly, when it is judged that the Y stage 6Y is at a position at which the detection light provided by the second detection-light unit D12 is irradiated onto the movement mirror 7Y, then the stage control section 12 shuts off or closes the shutter Sh2 of the second detection-light unit D12, and the stage control section 12 opens the shutter Sh4 of the fourth detection-light unit D14 which does not irradiate the detection light onto the movement mirror 7Y.

Therefore, when the Y stage 6Y is at the position at which the detection light provided by the first detection-light unit D11 is irradiated onto the movement mirror 7Y, the first detection light provided by the first detection-light unit D11 and the third reference light provided by the third detection-light unit D13 simultaneously come into the detecting section 21a; and the detecting section 21a detects the interference fringe brought about by the interference between the first detection light and the third reference light to thereby measure the position in the Y direction of the movement mirror 7Y, i.e., the position in the Y direction of the plate stage 6. On the other hand, when the Y stage 6Y is at the position at which the detection light provided by the third detection-light unit D13 is irradiated onto the movement mirror 7Y, the third detection light provided by the third detection-light unit D13 and the first reference light provided by the first detection-light unit D11 simultaneously come into the detecting section 21a; and the detecting section 21a detects the interference fringe brought about by the interference between the third detection light and the first reference light to thereby measure the position in the Y direction of the movement mirror 7Y, i.e., the position in the Y direction of the plate stage 6.

Similarly, when the Y stage 6Y is at a position at which the detection light provided by the second detection-light unit D12 is irradiated onto the movement mirror 7Y, the second detection light provided by the second detection-light unit D12 and the fourth reference light provided by the fourth detection-light unit D14 simultaneously come into the detecting section 21b; and the detecting section 21b detects the interference fringe brought about by the interference between the second detection light and the fourth reference light to thereby measure the position in the Y direction of the movement mirror 7Y, i.e., the position in the Y direction of the plate stage 6. On the other hand, when the Y stage 6Y is at a position at which the detection light provided by the fourth detection-light unit D14 is irradiated onto the movement mirror 7Y, the fourth detection light provided by the fourth detection-light unit D14 and the second reference light provided by the second detection-light unit D12 simultaneously come into the detecting section 21b; and the detecting section 21b detects the interference fringe brought about by the interference between the fourth detection light and the second reference light to thereby measure the position in the Y direction of the movement mirror 7Y, i.e., the position in the Y direction of the plate stage 6.

In the third embodiment, the frequency difference is generated by each of the frequency modulators 24a, 24b between the first detection light and the third reference light, between the third detection light and the first reference light, between the second detection light and the fourth reference light, or between the fourth detection light and the second reference light. The detecting section 21a or the detecting section 21b performs the heterodyne detection of the interference signal having the frequency equivalent to the frequency difference to measure the position in the Y direction of the movement mirror 7Y. Accordingly, it is possible to highly accurately detect the position in the Y direction of the Y stage 6Y.

For example, in a case that the Y stage 6Y is moved in the +X direction in the state shown in Fig. 7, the measured value, which is measured by the detecting section 21a based on the detection light concerning the position measuring axis 17Y1, is delivered or transferred (initially set) as the initial value for the measured value of the detecting section 21b based on the detection light concerning the position measuring axis 17Y2, now irradiating the movement mirror 7Y simultaneously with the detection light concerning the position measuring axis 17Y1, in accordance with the movement of the movement mirror 7Y. The same procedure is also adopted for the position measuring axes 17Y2 and 17Y3 and the position measuring axes 17Y3 and 17Y4 to be used thereafter. The same procedure is also adopted in a case that the plate stage 6 is moved in the -X direction.

In this case, the Y stage 6Y sometimes finely rotates (generates fine rotation) the Z axis in accordance with the movement thereof; and when the fine rotation is generated upon the delivery or transfer of the measured value, if the measured value concerning the position measuring axis disposed on the upstream side, i.e., the measured value of the detecting section which has performed the measurement before the delivery, is delivered as it is as the initial value for the measured value concerning the position measuring axis disposed on the downstream side, i.e., the initial value of the measured value of the detecting section which is to succeed the measurement after the delivery, then any error, which corresponds to the fine rotation, is included in the initial value, and it is feared that the measurement accuracy might be lowered. In the third embodiment, as described above, the fine angle of rotation about the Z axis of the Y stage 6Y is detected by the X interferometer unit 16X, and the initial value, which is delivered to the position measuring axis disposed on the downstream side, is set based on the detected fine angle of rotation and the measured value concerning the position measuring axis disposed on the upstream side. Accordingly, it is possible to perform the correct position measurement.

The measured values obtained by the detecting sections 21a, 21b respectively are supplied to the stage control section 12; and the control section 12 performs the process such as the delivery or the like in which the measured value concerning the detection light on the upstream side is delivered as the initial value concerning the detection light on the downstream side. The stage control section 12 controls the movement of the plate stage 6 based on the measured values obtained by the X interferometer unit 16X and the Y interferometer unit 16Y.

According to the stage position measuring apparatus or device concerning the third embodiment described above, it is possible to provide the effects which are same as or equivalent to those of the stage position measuring apparatus or device concerning the first embodiment. The 1/2 wavelength plates 25a to 25d for adjusting the light amounts are provided on the upstream sides of the first to fourth detection-light units D11 to D14 respectively (on the sides of the laser light source). Therefore, it is possible to uniformly distribute, among the units, the light amounts of the detection lights irradiated onto the movement mirror 7Y 4 from the first to fourth detection-light units D11 to D1 respectively and the light amounts of the reference lights irradiated onto the fixed mirrors RM1 to RM4, by appropriately setting the angles of rotation in relation to the polarizing beam splitters D1a to D4a respectively. Even in a case that the detection-light unit or units is/are added, it is possible to uniformize the powers (light amounts) of the reference lights and the respective detection lights among the units by appropriately setting the angles of rotation of the 1/2 wavelength plates 25a to 25d depending on the number of the unit or units. However, it is also allowable that all of the reference lights and the respective detection lights are not uniformized within a range of the light amount in which the detection can be performed stably by the respective detecting sections 21a, 21b.

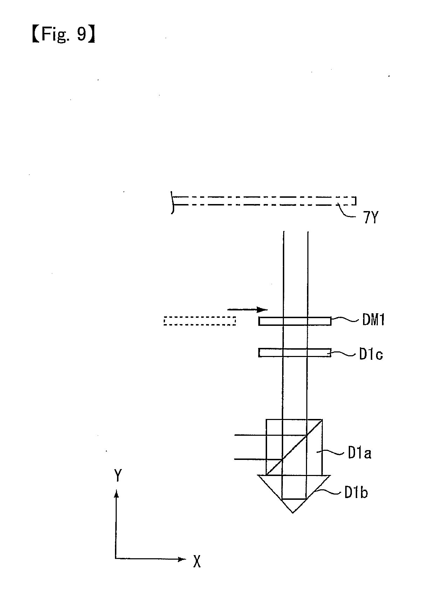

The third embodiment described above is constructed such that in the first to fourth detection-light units D11 to D14, the lights are branched by the half mirrors D1f to D4f, and the fixed mirrors RM1 to RM4 are provided with the shutters Sh1 to Sh4 intervening therebetween. However, as shown in Fig. 9, a movable mirror DM1 (DM2 to DM4), which is insertable/retractable (withdrawable) with respect to the optical path, may be provided for the 1/4 wavelength plate D1c (D2c, D3c, D4c) on the side of the movement mirror 7Y. Accordingly, it is possible to selectively switch the detection light and the reference light coming into each of the corresponding detecting sections 21a, 21b without branching the lights by the half mirrors D1f to D4f in the first to fourth detection-light units. Thus, it is possible to reduce the light amount loss of the detection light and the reference light which would be otherwise caused by the branching. The movable mirror, which is accompanied by the driving function as described above, can be also applied to the following fourth embodiment. Further, the movable mirrors as described above may be arranged, instead of the shutters Sh1 to Sh4.

### Fourth Embodiment

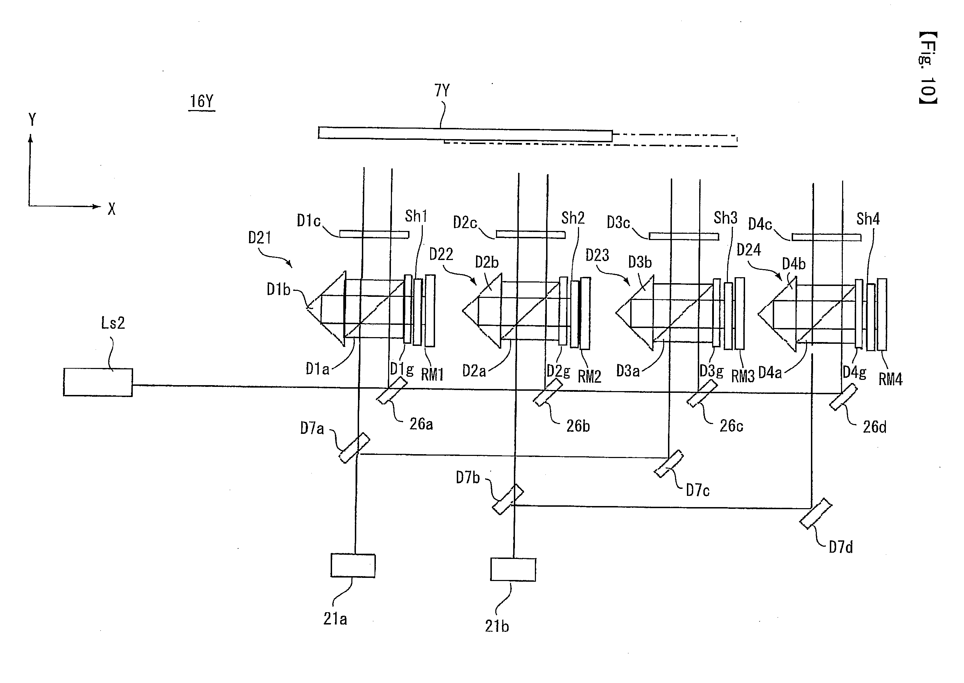

Next, a fourth embodiment of the present invention will be explained with reference to Fig. 10. The constitutive components or parts, which are the same as those shown in Figs. 5 and 6 or Fig. 8, are designated by the same reference numerals, any explanation of which will be appropriately omitted.

Fig. 10 shows a plan view illustrating a construction of a stage position measuring apparatus or device according to the fourth embodiment of the present invention. A Y interferometer unit 16Y includes a laser light source (for example, Zeeman laser) Ls2 which outputs (radiates) laser beams including two linearly polarized lights (P-polarized light or P-polarized beam, S-polarized light of S-polarized light beam) having different frequencies and having mutually perpendicular polarization planes, and a pair of detecting sections 21a, 21b. The Y interferometer unit 16Y further includes first to fourth detection-light units D21 to D24, a reflected-light unit, and a light distribution unit which include a plurality of optical elements respectively. In this case, a first position measuring module is constructed by using the detecting section 21a and the first and third detection-light units D21, D23 provided corresponding to the position measuring axes 17Y1, 17Y3 disposed in the odd-numbered columns, and a second position measuring module is constructed by using the detecting section 21b and the second and fourth detection-light units D22, D24 provided corresponding to the position measuring axes 17Y2, 17Y4 disposed in the even-numbered columns.

The first detection-light unit D21 includes a polarizing beam splitter D1a, a corner cube D1b, 1/4 wavelength plates D1c, D1g, a shutter Sh1, and a fixed mirror RM1. The second detection-light unit D22 includes a polarizing beam splitter D2a, a corner cube D2b, 1/4 wavelength plates D2c, D2g, a shutter Sh2, and a fixed mirror RM2. The third detection-light unit D23 includes a polarizing beam splitter D3a, a corner cube D3b, 1/4 wavelength plates D3c, D3g, a shutter Sh3, and a fixed mirror RM3. The fourth detection-light unit D24 includes a polarizing beam splitter D4a, a corner cube D4b, 1/4 wavelength plates D4c, D4g, a shutter Sh4, and a fixed mirror RM4. The reflected-light unit includes mirrors D7a to D7d. The mirrors D7c, D7d are total reflection mirrors, and the mirrors D7a, D7b are half mirrors to serve as optical path combining elements. The first to fourth detection-light units D21 to D24 also serve as the reference-light units respectively as described later on.

The light distribution unit is a unit which uniformly distributes the laser beam (P-polarized light, S-polarized light) radiated from the laser light source Ls2 to the respective detection-light units D21 to D24. The light distribution unit includes partial transmission mirrors 26a to 26c and a total reflection mirror 26d. The laser beam, which is radiated from the laser light source Ls2, comes into the partial transmission mirror 26a which reflects 25 % of the incident light and through which 75 % of the incident light is transmitted. The reflected light comes into the first detection-light unit D21, and the transmitted light comes into the partial transmission mirror 26b. The partial transmission mirror 26b reflects 33 % of the incident light, and 67 % of the incident light is transmitted therethrough. The reflected light comes into the second detection-light unit D22, and the transmitted light comes into the partial transmission mirror 26c. The partial transmission mirror 26c reflects 50 % of the incident light, and 50 % of the incident light is transmitted therethrough. The reflected light comes into the third detection-light unit D23, and the transmitted light comes into the total reflection mirror 26d. All of the incident light is reflected by the total reflection mirror 26d, and the light comes into the fourth detection-light unit D24.

The P-polarized light of the laser beam reflected by the partial transmission mirror 26a and coming into the polarizing beam splitter D1a is transmitted through the polarizing beam splitter D1a; and the light is converted into the circularly polarized light by the 1/4 wavelength plate D1c, and the light is irradiated as the detection light onto the movement mirror 7Y. The reflected light, which is reflected in the -Y direction by the movement mirror 7Y, is converted into the linearly polarized light by the 1/4 wavelength plate D1c again. The light exiting in the -Y direction from the 1/4 wavelength plate D1c has the polarization plane which is rotated by 90 degrees with respect to the polarization plane of the light coming in the +Y direction into the 1/4 wavelength plate D1c.

The light exiting in the -Y direction from the 1/4 wavelength plate D1c comes into the polarizing beam splitter D1a, and the light is reflected in the -X direction by the polarizing beam splitter D1a; and the light is reflected in the +X direction by the corner cube D1b, and the light is reflected in the +Y direction by the polarizing beam splitter D1a. The light is converted into the circularly polarized light by the 1/4 wavelength plate D1c, and the light is irradiated as the detection light onto the movement mirror 7Y again. The reflected light, which is reflected in the -Y direction by the movement mirror 7Y, is converted into the linearly polarized light by the 1/4 wavelength plate D1c again. The light from the 1/4 wavelength plate D1c is transmitted through the polarizing beam splitter D1a; and the light is further transmitted through the mirror D7a, and the light comes into the detecting section 21a as the first detection light.

On the other hand, the S-polarized light of the laser beam, which is reflected by the partial transmission mirror 26a and which comes into the polarizing beam splitter D1a, is reflected in the +X direction by the polarizing beam splitter D1a; and the light is converted into the circularly polarized light by the 1/4 wavelength plate D1g, and the light is radiated as the reference light onto the fixed mirror RM1 when the shutter Sh1 is open. The light is reflected by the fixed mirror RM1, and the light is converted into the linearly polarized light by the 1/4 wavelength plate D1g again. The light exiting in the - X direction from the 1/4 wavelength plate D1g has the polarization plane which is rotated by 90 degrees with respect to the polarization plane of the light coming in the +X direction into the 1/4 wavelength plate D1g.

The light exiting in the -X direction from the 1/4 wavelength plate D1g is transmitted through the polarizing beam splitter D1a, and the light is reflected in the +X direction by the corner cube D1b; and the light is transmitted through the polarizing beam splitter D1a, and the light is converted into the circularly polarized light by the 1/4 wavelength plate D1g. The light is irradiated as the reference light onto the fixed mirror RM1 again. The reflected light, which is reflected in the -Y direction by the fixed mirror RM1, is converted into the linearly polarized light by the 1/4 wavelength plate D1g again. The light from the 1/4 wavelength plate D1g is reflected in the -Y direction by the polarizing beam splitter D1a; and the light is transmitted through the mirror D7a, and the light comes into the detecting section 21a as the first reference light.

Further, the P-polarized light of the laser beam, which is reflected by the partial transmission mirror 26b and which comes into the polarizing beam splitter D2a, is irradiated as the detection light onto the movement mirror 7Y twice via the polarizing beam splitter D2a, the 1/4 wavelength plate D2c, and the corner cube D2b in the same manner as the P-polarized light of the laser beam coming into the polarizing beam splitter D1a. The light, which is reflected by the movement mirror 7Y for the second time, is converted into the linearly polarized light by the 1/4 wavelength plate D2c; and the light is transmitted through the polarizing beam splitter D2a. The light further transmitted through the mirror D7b, and the light comes into the detecting section 21b as the second detection light.

On the other hand, the S-polarized light of the laser beam, which is reflected by the partial transmission mirror 26b and which comes into the polarizing beam splitter D2a, is irradiated as the reference light onto the fixed mirror RM2 twice via the polarizing beam splitter D2a, the 1/4 wavelength plate D2g, and the corner cube D2b when the shutter Sh2 is open, in the same manner as the S-polarized light of the laser beam coming into the polarizing beam splitter D1a. The light, which is reflected by the fixed mirror RM2 for the second time, is converted into the linearly polarized light by the 1/4 wavelength plate D2g, and the light is reflected in the -Y direction by the polarizing beam splitter D2a. The light is transmitted through the mirror D7b, and the light comes into the detecting section 21b as the second reference light.

Further, the P-polarized light of the laser beam, which is reflected by the partial transmission mirror 26c and which comes into the polarizing beam splitter D3a, is irradiated as the detection light onto the movement mirror 7Y twice via the polarizing beam splitter D3a, the 1/4 wavelength plate D3c, and the corner cube D3b in the same manner as the P-polarized light of the laser beam coming into the polarizing beam splitter D1a. The reflected light, which is reflected by the movement mirror 7Y for the second time, is converted into the linearly polarized light by the 1/4 wavelength plate D3c; and the light is transmitted through the polarizing beam splitter D3a. The light is further transmitted through the mirror D7b, and the light comes into the detecting section 21a as the third detection light.

On the other hand, the S-polarized light of the laser beam, which is reflected by the partial transmission mirror 26c and which comes into the polarizing beam splitter D3a, is irradiated as the reference light onto the fixed mirror RM3 twice via the polarizing beam splitter D3a, the 1/4 wavelength plate D3g, and the corner cube D3b when the shutter Sh3 is open, in the same manner as the S-polarized light of the laser beam coming into the polarizing beam splitter D1a. The light, which is reflected by the fixed mirror RM3 for the second time, is converted into the linearly polarized light by the 1/4 wavelength plate D3g, and the light is reflected in the -Y direction by the polarizing beam splitter D3a; and the light is reflected by the mirror D7c. The light is reflected in the -Y direction by the mirror D7a, and the light comes into the detecting section 21a as the third reference light.

Further, the P-polarized light of the laser beam, which is reflected by the total reflection mirror 26d and which comes into the polarizing beam splitter D4a, is irradiated as the detection light onto the movement mirror 7Y twice via the polarizing beam splitter D4a, the 1/4 wavelength plate D4c, and the corner cube D4b in the same manner as the P-polarized light of the laser beam coming into the polarizing beam splitter D1a. The light, which is reflected by the movement mirror 7Y for the second time, is converted into the linearly polarized light by the 1/4 wavelength plate D4c; and the light is transmitted through the polarizing beam splitter D4a, and the light is further reflected by the mirror D7d. The light is reflected in the -Y direction by the mirror D7b, and the light comes into the detecting section 21b as the fourth detection light.

On the other hand, the S-polarized light of the laser beam, which is reflected by the total reflection mirror 26d and which comes into the polarizing beam splitter D4a, is irradiated as the reference light onto the fixed mirror RM4 twice via the polarizing beam splitter D4a, the 1/4 wavelength plate D4g, and the corner cube D4b when the shutter Sh4 is open, in the same manner as the S-polarized light of the laser beam coming into the polarizing beam splitter D1a. The light, which is reflected by the fixed mirror RM4 for the second time, is converted into the linearly polarized light by the 1/4 wavelength plate D4g; and the light is reflected in the -Y direction by the polarizing beam splitter D4a, and the light is reflected by the mirror D7d. The light is reflected in the -Y direction by the mirror D7b, and the light comes into the detecting section 21b as the fourth reference light.

When any other detection-light unit is provided on the downstream side of the fourth detection-light unit D24, the mirror D7c and the mirror D7d are half mirrors to serve as optical path combining elements in the same manner as the mirror D7a or the mirror D7b.

The operations (opening or closing) of the shutters Sh1 to Sh4 of the detection-light units D21 to D24 respectively are controlled by the stage control section 12 depending on the position in the X axis direction of the plate stage 6 (Y stage 6Y). Specifically, the stage control section 12 appropriately distinguishes the detection-light unit which irradiates the detection light onto the movement mirror 7Y and the detection-light unit which does not irradiate the detection light onto the movement mirror 7Y, based on the measured value obtained by the X interferometer unit 16X. The stage control section 12 performs the control as follows. That is, the optical path for the reference light is opened by opening the shutter of the detection-light unit which irradiates the detection light onto the movement mirror 7Y, and the optical path for the reference light is closed by closing the shutter of the detection-light unit which does not irradiate the detection light onto the movement mirror 7Y. For example, when it is judged that the Y stage 6Y is at a position at which the detection light provided by the first detection-light unit D21 is irradiated onto the movement mirror 7Y, then the stage control section 12 opens the shutter Sh1 of the first detection-light unit D21, and the stage control section 12 shuts off or closes the shutter Sh3 of the third detection-light unit D23 which does not irradiate the detection light onto the movement mirror 7Y. Similarly, when it is judged that the Y stage 6Y is at a position at which the detection light provided by the second detection-light unit D22 is irradiated onto the movement mirror 7Y, then the stage control section 12 opens the shutter Sh2 of the second detection-light unit D22, and the stage control section 12 shuts off or closes the shutter Sh4 of the fourth detection-light unit D24 which does not irradiate the detection light onto the movement mirror 7Y.

Therefore, when the Y stage 6Y is at the position at which the detection light provided by the first detection-light unit D21 is irradiated onto the movement mirror 7Y, the first detection light provided by the first detection-light unit D21 and the first reference light provided by the first detection-light unit D21 simultaneously come into the detecting section 21a; and the detecting section 21a detects the interference fringe brought about by the interference between the first detection light and the first reference light to thereby measure the position in the Y direction of the movement mirror 7Y, i.e., the position in the Y direction of the plate stage 6. On the other hand, when the Y stage 6Y is at the position at which the detection light provided by the third detection-light unit D23 is irradiated onto the movement mirror 7Y, the third detection light provided by the third detection-light unit D23 and the third reference light provided by the third detection-light unit D23 simultaneously come into the detecting section 21a; and the detecting section 21a detects the interference fringe brought about by the interference between the third detection light and the third reference light to thereby measure the position in the Y direction of the movement mirror 7Y, i.e., the position in the Y direction of the plate stage 6.

Similarly, when the Y stage 6Y is at the position at which the detection light provided by the second detection-light unit D24 is irradiated onto the movement mirror 7Y, the second detection light provided by the second detection-light unit D24 and the second reference light provided by the second detection-light unit D22 simultaneously come into the detecting section 21b; and the detecting section 21b detects the interference fringe brought about by the interference between the second detection light and the second reference light to thereby measure the position in the Y direction of the movement mirror 7Y, i.e., the position in the Y direction of the plate stage 6. On the other hand, when the Y stage 6Y is at the position at which the detection light provided by the fourth detection-light unit D24 is irradiated onto the movement mirror 7Y, the fourth detection light provided by the fourth detection-light unit D24 and the fourth reference light provided by the fourth detection-light unit D24 simultaneously come into the detecting section 21b; and the detecting section 21b detects the interference fringe brought about by the interference between the fourth detection light and the fourth reference light to thereby measure the position in the Y direction of the movement mirror 7Y, i.e., the position in the Y direction of the plate stage 6.

In the fourth embodiment, the frequency difference is generated by the Zeeman laser, etc. between the first detection light and the first reference light, between the third detection light and the third reference light, between the second detection light and the second reference light, or between the fourth detection light and the fourth reference light. The detecting section 21a or the detecting section 21b performs the heterodyne detection of the interference signal having the frequency equivalent to the frequency difference to measure the position in the Y direction of the movement mirror 7Y. Accordingly, it is possible to highly accurately detect the position in the Y direction of the Y stage 6Y.

The delivery or transfer of the initial value to the position measuring axis disposed on the downstream side and the setting thereof are the same as or equivalent to those described in the foregoing third embodiment.

According to the stage position measuring apparatus or device according to the fourth embodiment described above, it is possible to provide the effects which are the same as or equivalent to those of the stage position measuring apparatus or device according to the first member.

Further, every 25 % of the light radiated from the laser light source Ls2 can be used the reference light and as each of the detection lights. In a case that the detection-light unit or units is/are added, the transmittances of the partial transmission mirrors 26a to 26d and an additional partial transmission mirror or mirrors are appropriately set depending on the number thereof, to thereby make it possible to uniformize the powers the reference light and the respective detection lights). It goes without saying that the light amount is adjusted by changing the transmittance of the partial transmission mirror depending on the number of the constitutive detection-light units. However, it is also allowable that all of the reference light and the respective detection lights are not uniform or equivalent provided that the light amount is within a range in which the detection can be stably performed in each of the detecting sections 21a, 21b.

In the first to fourth embodiments explained above, the respective position measuring axes 17Y1 to 17Y4 are disposed in the X axis direction at such intervals that the three detection lights, which are included in the detection lights irradiated on the position measuring axes, respectively, are not simultaneously irradiated onto the movement mirror 7Y. However, the present invention is not limited to this arrangement (construction) except that the measured value is delivered or transferred between the adjacent position measuring axes, i.e., between the first and second position measuring modules. It is enough to adopt such intervals that the four detection lights are not simultaneously irradiated onto the movement mirror 7Y. In general, the respective position measuring axes of the first and second position measuring modules may be disposed at such intervals that the four detection lights in total of the detection lights irradiated on the two position measuring axes included in the first position measuring module and the detection lights irradiated on the two position measuring axes included in the second position measuring module are not simultaneously irradiated onto the movement mirror 7Y. In other words, it is appropriate that the axis-to-axis distance, which ranges from the axis disposed at one end to the axis disposed at the other end of the four position measuring axes disposed in the X axis direction, is larger than the size or dimension in the X axis direction of the reflecting surface of the movement mirror 7Y.

By arranging the respective position measuring axes as described above, the detection light from any one of the position measuring axes of the first and second position measuring modules comes into one detecting section of the detecting sections 21a, 21b, irrelevant to the position of the movement mirror 7Y (plate stage 6). Therefore, it is possible to measure the position in the Y axis direction of the movement mirror 7Y over the entire movement range in the X axis direction based on the detection light. In a case that the measured value is delivered or transferred between the first and second position measuring modules depending on the position in the X axis direction of the movement mirror 7Y, the detection light from one position measuring axis comes into each of the detecting sections 21a, 21b. Therefore, it is possible to correctly perform the delivery or transfer of the measured value.

In the third and fourth embodiments described above, the shutters Sh1 to Sh4 are arranged on the optical paths for the reference lights for the position measuring axes 17Y1 to 17Y4 respectively to selectively open and shut off the optical paths for the reference lights. However, the construction or arrangement is not limited to the optical path for the reference light. The shutter may be further arranged on the optical path for any detection light. By doing so, even in a case that, for example, the three or more detection lights are simultaneously irradiated onto the movement mirror 7Y, the measured value can be delivered or transferred between the first and second position measuring modules at a desired timing by appropriately shutting off the optical path for the detection light. In this case, it is possible to mitigate the condition in relation to the arrangement interval of each of the position measuring axes; and thus it is possible to expand the degree of freedom of the arrangement of the first and second position measuring modules.

In the first to fourth embodiments described above, the two position measuring modules, i.e., the first and second position measuring modules are used. However, the number of modules is not limited to two; and it is possible to provide three or more modules. In this case, the respective position measuring modules may be provided such that each one of the position measuring axes of one position measuring module, among the position measuring modules, is arranged between the first and second position measuring axes of the other position measuring module. Also in this case the reference-light unit, the laser light source, the frequency modulator, etc. can be commonly used between the respective position measuring modules in the same manner as in the first and second position measuring modules described above.

### Device Production Method

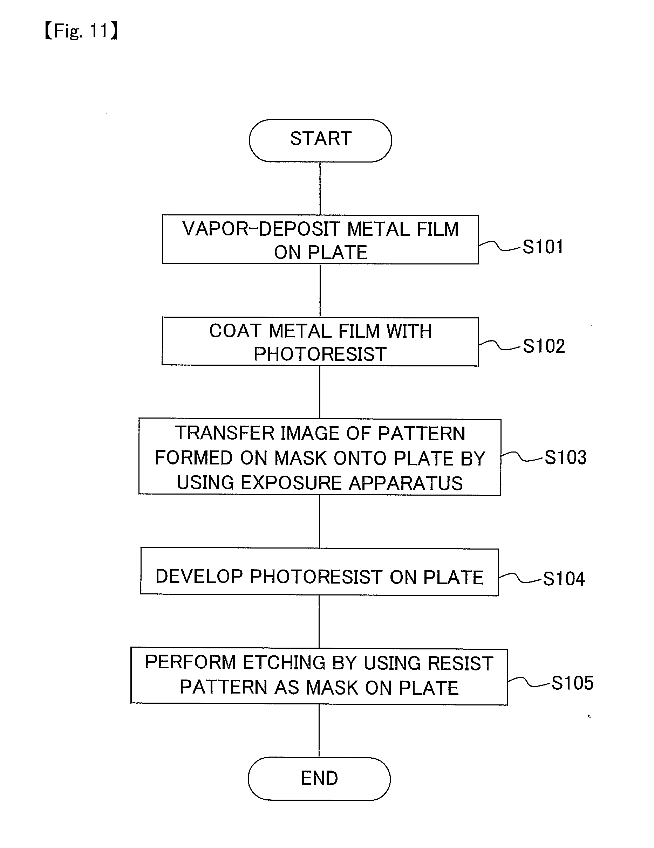

In the exposure apparatus of each of the embodiments described above, it is possible to produce the device including a liquid crystal display element, a semiconductor element, an image pickup element, a thin film magnetic head, etc., by performing an exposure step in which a transfer pattern formed on the mask M is transferred to a photosensitive substrate (plate) to perform the exposure and performing a development step in which the exposed and transferred pattern is developed. An explanation will be made below with reference to a flow chart shown in Fig. 11 about an exemplary method or technique in which a semiconductor device as a microdevice is obtained by forming a predetermined circuit pattern on a plate, etc. as a photosensitive substrate by using the exposure apparatus concerning any one of the embodiments described above.

At first, in Step S101 shown in Fig. 11, a metal film is vapor-deposited on a plate P. Subsequently, in Step S102, the metal film on the plate P is coated with a photoresist. After that, in Step S103, an image of a pattern formed on a mask M is successively transferred to respective shot areas on the plate P via the projection optical system PL to perform the exposure by using the exposure apparatus according to any one of the embodiments described above. After that, in Step S104, the photoresist on the plate P is developed. After that, in Step S105, the etching is performed by using a resist pattern (transferred pattern layer) as a processing mask on the plate P, and thus a circuit pattern corresponding to the pattern of the mask M is formed on the plate P.

After that, the device such as the semiconductor element or the like is produced, for example, by forming a circuit pattern of an upper layer disposed thereover, etc. According to the semiconductor device production method described above, the semiconductor device can be produced at the low cost. In Steps S101 to S105, the metal is vapor-deposited on the plate P, and the metal film is coated with the resist to perform the respective steps of the exposure, the development, and the etching. However, it goes without saying that a silicon oxide film may be formed on the plate P prior to the steps as described above, and then the silicon oxide film may be coated with the resist to perform the respective steps of the exposure, the development, and the etching.

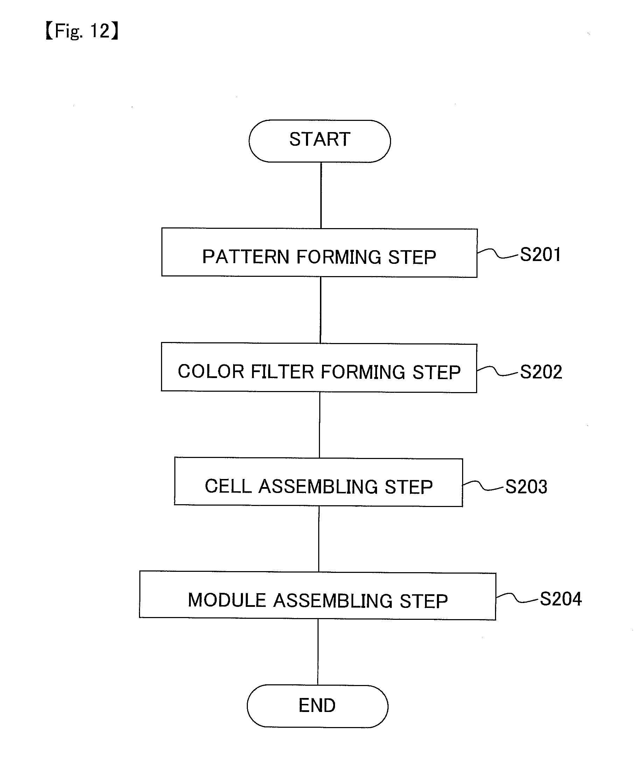

In the exposure apparatus concerning each of the embodiments described above, a liquid crystal device such as a liquid crystal display element or the like can be also obtained by forming a predetermined pattern (for example, a circuit pattern or an electrode pattern) on a plate (glass substrate) P. An explanation will be made below about an exemplary technique for this method with reference to a flow chart shown in Fig. 12. At first, in Fig. 12, in a pattern forming step S201, a so-called photolithography step is executed, wherein an image of a pattern of a mask M is transferred to a photosensitive substrate as a plate P (for example, a glass substrate coated with a resist) to perform the exposure by using the exposure apparatus according to any one of the embodiments described above. A predetermined pattern including, for example, a large number of electrodes is formed on the photosensitive substrate in accordance with the photolithography step. After that, the exposed substrate is subjected to the respective steps including the development step, the etching step, the resist exfoliation step, etc., and thus the predetermined pattern is formed on the substrate. The procedure proceeds to the next color filter forming step S202.

Subsequently, in the color filter forming step S202, a color filter is formed, wherein a large number of sets each composed of three dots corresponding to R (Red), G (Green), and B (Blue) are disposed in a matrix form, or a plurality of sets of filters each composed of three stripes of R, G, and B are disposed in the horizontal scanning line direction. Further, a cell assembling step S203 is executed after the color filter forming step S202. In the cell assembling step S203, for example, the liquid crystal is injected into the space between the substrate having the predetermined pattern obtained in the pattern forming step S201 and the color filter obtained in the color filter forming step S202 to produce a liquid crystal panel (liquid crystal cell).

After that, in a module assembling step S204, the liquid crystal display element is completed by attaching respective parts including a backlight, an electric circuit for performing the display operation of the assembled liquid crystal panel (liquid crystal cell), etc.. According to the method for producing the liquid crystal display element described above, it is possible to produce the liquid crystal display element with good productivity at the low cost.

The embodiments explained above have been described so that the present invention is understood more easily, and are not intended to limit the present invention. Therefore, in this meaning, the respective elements, which are disclosed in the respective embodiments described above, also include all of modifications of design and equivalents belonging to the technical scope of the present invention.

For example, in the embodiments described above, the ultra-high voltage mercury lamp is used as the light source. However, it is possible to use, for example, the KrF excimer laser beam (wavelength: 248 nm), the ArF excimer laser beam (wavelength: 193 nm), the F₂ laser beam (wavelength: 157 nm), or the Ar₂ laser beam (wavelength: 126 nm), etc. It is also allowable to use, for example, the high harmonic wave of the solid laser including, for example, the YAG laser having the oscillation spectrum at any one of the wavelengths of 248 nm, 193 nm, and 157 nm.

It is also allowable to use the high harmonic wave obtained such that the single wavelength laser in the ultraviolet region or the visible region, which is oscillated from the DFB semiconductor laser or the fiber laser, is amplified by a fiber amplifier doped, for example, with erbium (or both of erbium and ytterbium), and the wavelength is converted into the wavelength of the ultraviolet light by using the nonlinear optical crystal. Further, it is also allowable to use the laser plasma light source or the EUV (Extreme Ultra Violet) light having a wavelength of, for example, 13.4 nm or 11.5 nm in the soft X-ray region generated from SOR. Further, it is also allowable to use the charged particle beam such as the ion beam or the electron beam.

In the respective embodiments described above, those having the first to fourth detection-light units D1 to D4, D11 to D14, or D21 to D24 are described by way of example. However, it goes without saying to adopt such an construction that the first and second detection-light units D1 and D2, D11 and D23, or D21 and D22 are used as minimum units, and the number of units is increased two by two. The embodiment, in which the first to fourth detection-light units are used for the plate stage 6, is described by way of example. However, the first to fourth detection-light units may be used for the mask stage 5. The exposure apparatus, which is provided with the plurality of partial projection optical systems, is explained. However, the present invention is also applicable to an exposure apparatus provided with only one projection optical system. It is also allowable that the present invention is applied to a mask-less exposure apparatus in which DMD (digital micromirror device) or the like as an optical modulator is used as the mask M, and any mask previously formed with the pattern is not used.

It is a matter of course that the position measuring apparatus or device according to the present invention is preferably usable for the exposure apparatus described above. However, the present invention is not limited to the exposure apparatus as described above. The present invention is applicable to any other apparatus or device provided with the stage apparatus for moving the object (movable member).

The disclosure of the present invention relates to the subject matter included in Japanese Patent Application No. 2007-057939 filed on March 8, 2007, the entire disclosure of which is clearly incorporated herein by reference.

## Claims

1. A position measuring module comprising:
a movement mirror which is provided on a movable member and which has a reflecting surface along a first axis direction;
detection-light units which are arranged for a plurality of measuring axes disposed in the first axis direction respectively and which irradiate, onto the movement mirror, detection lights in a second axis direction intersecting the first axis direction;
a reference-light unit which includes a fixed mirror fixed to a member different from the movable member and which irradiates a reference light onto the fixed mirror;
a plurality of optical path combining elements which perform optical path combination of detection optical paths for the detection lights reflected by the movement mirror in relation to the measuring axes respectively or which perform optical path combination of the detection optical paths and a reference optical path for the reference light via the reference-light unit; and
a detecting section which detects an interference fringe brought about by interference between the detection light and the reference light coming into the detecting section via the optical path combining element and which measures a position of the movable member in the second axis direction based on a detection result of the interference fringe.

2. The position measuring module according to claim 1, wherein the measuring axes are disposed at intervals at which two or more of the detection lights are not simultaneously irradiated onto the movement mirror.

3. The position measuring module according to claim 1 or 2, wherein the measuring axes are disposed in a movement range of the movable member in the first axis direction.

4. The position measuring module according to any one of claims 1 to 3, wherein the reference-light unit includes a selective radiation mechanism which is provided for each of the measuring axes and which selectively performs irradiation and non-irradiation of the reference light with respect to the fixed mirror.

5. The position measuring module according to claim 4, further comprising a selective irradiation control section which selectively operates the selective irradiation mechanism of the reference-light unit corresponding to the second detection-light unit adjacent to the first detection-light unit which irradiates the detection light onto the movement mirror.

6. The position measuring module according to claim 4, further comprising a selective irradiation control section which selectively operates the selective irradiation mechanism of the reference-light unit corresponding to the detection-light unit which irradiates the detection light onto the movement mirror.

7. The position measuring module according to any one of claims 4 to 6, wherein the selective radiation mechanism includes at least one of a shutter mechanism which selectively opens or closes the optical path for the reference light with respect to the fixed mirror and an inserting/retracting mechanism which selectively inserts/retracts the fixed mirror with respect to the optical path for the detection light.

8. The position measuring module according to any one of claims 1 to 3, wherein the detecting section detects a first interference fringe brought about by the detection light via the first detection-light unit and the reference light via the reference-light unit, or a second interference fringe brought about by the detection light via the second detection-light unit and the reference light, depending on a position of the movable member in the first axis direction.

9. The position measuring module according to any one of claims 1 to 8, further comprising a frequency modulator which changes a frequency of at least one of the detection light and the reference light to generate a frequency difference between the detection light and the reference light,
wherein the detecting section heterodyne-detects the interference fringe.

10. The position measuring module according to claim 9, wherein the frequency modulator is provided for each of the measuring axes to make an amount of change of the frequency be different among the measuring axes.

11. The position measuring module according to any one of claims 1 to 8, further comprising a light source device which radiates the detection light and the reference light having different frequencies and different polarization planes,
wherein the detecting section heterodyne-detects the interference fringe.

12. The position measuring module according to any one of claims 1 to 10, further comprising:
a light source device which supplies a laser beam to the plurality of detection-light units; and
a light amount adjusting mechanism which adjusts a branching light amount ratio of the laser beam branched as the detection lights for the measuring axes respectively.

13. The position measuring module according to claim 12, wherein the light source device supplies the laser beam as a linearly polarized light, and the light amount adjusting mechanism includes a 1/2 wavelength plate through which the laser beam is transmitted.

14. A position measuring apparatus comprising:
a plurality of pieces of the position measuring module as defined in any one of claims 1 to 13,
wherein a measuring axis of a second position measuring module is arranged between first and second measuring axes of a first position measuring module included in the plurality of position measuring modules.

15. The position measuring apparatus according to claim 14, wherein the measuring axis of the first position measuring module and the measuring axis of the second position measuring module are arranged with an interval narrower than a size of the reflecting surface of the movement mirror in the first axis direction.

16. The position measuring apparatus according to claim 14 or 15, wherein the first and second measuring axes of the first position measuring module and the measuring axis of the second position measuring module are arranged at intervals at which the detection lights radiated on the respective measuring axes are not simultaneously irradiated onto the movement mirror.

17. The position measuring apparatus according to any one of claims 14 to 16, wherein the first and second measuring axes of the first position measuring module and first and second position measuring axes of the second position measuring module are arranged at intervals at which the detection lights radiated on the respective measuring axes are not simultaneously irradiated onto the movement mirror.

18. The position measuring apparatus according to any one of claims 14 to 17, wherein the detection-light units of at least one of the first and second position measuring modules include a polarization adjusting element which provides, between the first and second position measuring modules, different polarization for the detection light coming into the detecting section.

19. The position measuring apparatus according to any one of claims 14 to 18, further comprising a measurement control section which sets a measurement initial value of the second position measuring module based on a position of the movable member in the first axis direction and a measurement result of the first position measuring module.

20. The position measuring apparatus according to claim 19, wherein the measurement control section sets, based on the measurement result obtained for the measuring axis of the first position measuring module, the measurement initial value for the measuring axis of the second position measuring module adjacent to the measuring axis of the first position measuring module.

21. The position measuring apparatus according to claim 19 or 20, further comprising a position sensor which measures a position of the movable member in the first axis direction,
wherein the measurement control section sets the measurement initial value based on a measurement result obtained by the position sensor.

22. The position measuring apparatus according to claim 21, wherein the position sensor measures the position in the first axis direction for a plurality of portions in the second axis direction of the movable member.

23. The position measuring apparatus according to claim 21 or 22, wherein the position sensor includes a laser interferometer.

24. A position measuring apparatus which measures a position of a movable member movable in two-dimensional directions of a first axis direction and a second axis direction perpendicular to the first axis direction, the position measuring apparatus comprising:
a plurality of measuring axes each of which measures a position of the movable member in the second axis direction, which are arranged separately in the first axis direction, and each of which measures the position of the movable member when the movable member is moved in the first axis direction; and
a plurality of detecting sections which are provided to be opposite to the measuring axes respectively and each of which detects the position of the movable member,
wherein a number of the detecting sections is smaller than a number of the measuring axes.

25. A stage apparatus comprising:
the position measuring apparatus as defined in any one of claims 14 to 23; and
a stage section which is provided with the movement mirror and which holds an object to move the object in the first axis direction and the second axis direction,
wherein the position measuring apparatus measures a position of the stage section as the position of the movable member.

26. An exposure apparatus which transfers an image of a pattern to a photosensitive substrate, the exposure apparatus comprising:
the position measuring apparatus as defined in any one of claims 14 to 23; and
a substrate stage which is provided with the movement mirror and which holds the photosensitive substrate to move the photosensitive substrate in the first axis direction and the second axis direction,
wherein the position measuring apparatus measures a position of the substrate stage as the position of the movable member.

27. The exposure apparatus according to claim 26, further comprising:
a mask stage which holds a mask formed with the pattern to move the mask in the first axis direction; and
an exposure control section which performs control to transfer the image of the pattern onto the photosensitive substrate while synchronously moving the substrate stage and the mask stage in the first axis direction.

28. A method for producing a device, comprising:
an exposure step of transferring an image of a pattern to a photosensitive substrate by using the exposure apparatus as defined in claim 26 or 27;
a development step of developing the photosensitive substrate to which the image of the pattern has been transferred so that a transfer pattern layer, which has a shape corresponding to the image of the pattern, is formed on the photosensitive substrate; and
a processing step of processing the photosensitive substrate via the transfer pattern layer.
